**Europäisches Patentamt**

**European Patent Office**

**Office européen des brevets**

(19)

(11) **EP 0 905 706 B1**

(12) **EUROPÄISCHE PATENTSCHRIFT**

(45) Veröffentlichungstag und Bekanntmachung des Hinweises auf die Patenterteilung:
**09.11.2005  Patentblatt 2005/45**

(51) Int Cl.⁷: **G11C 8/04**, G11C 7/00

(21) Anmeldenummer: **98115499.0**

(22) Anmeldetag: **17.08.1998**

(54) **Pointer-Schaltung mit geringem Flächenbedarf, hoher Geschwindigkeit und geringer Verlustleistung**

Pointer circuit with reduced surface, high speed and low power dissipation

Circuit pointeur de surface réduite, à vitesse élevée et à faible consommation

(84) Benannte Vertragsstaaten:
**DE FR GB IE IT**

(30) Priorität: **26.09.1997  DE 19742698**

(43) Veröffentlichungstag der Anmeldung:
**31.03.1999  Patentblatt 1999/13**

(73) Patentinhaber: **Infineon Technologies AG**
**81669 München (DE)**

(72) Erfinder:
 • **Schmitt-Landsiedel, Doris, Dr.**
  **85521 Ottobrunn (DE)**
 • **Thewes, Roland**
  **82194 Gröbenzell (DE)**

 • **Kollmer, Ute**
  **81737 München (DE)**
 • **Bollu, Michael, Dr.**
  **81671 München (DE)**
 • **von Basse, Paul-Werner**
  **82515 Wolfratshausen (DE)**
 • **Luck, Andreas**
  **81737 München (DE)**

(74) Vertreter:
**Patentanwaltskanzlei WILHELM & BECK**
**Nymphenburger Strasse 139**
**80636 München (DE)**

(56) Entgegenhaltungen:
**US-A- 5 444 660          US-A- 5 535 170**

**Beschreibung**

In bestimmten schaltungstechnischen Anordnungen werden sog. Pointer-Schaltungen benötigt, die eine vorgegebene Anzahl Ausgänge aufweisen und von diesen Ausgängen genau einen derart auswählen, daß dieser eine Ausgang als einziger auf einem bestimmten von zwei logisch unterscheidbaren Zuständen liegt, alle übrigen Ausgänge dagegen auf dem anderen logischen Zustand liegen und nicht ausgewählt sind.

Durch Eingabe eines Schiebetakt-Impulses kann der eine logische Zustand von dem ausgewählten Ausgang zu einem diesem Ausgang benachbarten nächsten Ausgang weiterverschoben werden, so daß danach der nächste Ausgang auf dem einen logischen Zustand liegt und ausgewählt ist, während alle übrigen Ausgänge einschließlich des einen auf dem anderen logischen Zustand liegen und nicht ausgewählt sind.

Derartige Pointer-Schaltungen können z.B. zur Auswahl einer Speicherzelle innerhalb einer Speichermatrix verwendet werden (siehe z.B.[1]).

Bei bisher bekannten derartigen Schaltungen werden konventionelle Schieberegister-Schaltungen verwendet, wobei die Ausgänge aller Register außer einem den bestimmten einen logischen Zustand enthalten.

Unabhängig von der verwendeten Technologie benötigen alle diese bisher bekannten Schaltungen eine relativ hohe Anzahl an Bauelementen pro Ausgang. Dieser relativ hohe Platzbedarf kann sich insbesondere bei Anwendung zur Auswahl einer Speicherzelle innerhalb einer Speichermatrix sehr nachteilig auswirken, da die Zeilen- und Spaltenanschlüsse bei bestimmten Technologien bzw. bei bestimmten Architekturvarianten des Zellenfeldes sehr geringe Abstände haben (siehe z.B. [1], [4] + [5]).

Der im Anspruch 1 angegebenen Erfindung liegt die Aufgabe zugrunde, eine Pointer-Schaltung bereitzustellen, deren Flächenbedarf geringer als bei den obengenannten bekannten Schaltungen ist.

Anders als die obengenannten bekannten Schaltungen in Form von Schieberegistern benötigt die erfindungsgemäße Pointer-Schaltung vorteilhafterweise keine Zwischenspeicherstufen. Das bedeutet, daß bei der erfindungsgemäßen Pointer-Schaltung vorteilhafterweise pro Ausgang nur genau ein Speicher benötigt wird. Dadurch wird der Aufwand an benötigten Bauelementen erheblich reduziert, was zu einem wesentlich geringeren Flächenbedarf gegenüber den obengenannten bekannten Schaltungen führt. Damit ist die erfindungsgemäße Pointer-Schaltung vorteilhaft zur Auswahl einer Speicherzelle innerhalb einer Speichermatrix zu verwenden, bei der die Zeilen- bzw. Spaltenleitungen sehr geringe Abstände aufweisen. Überdies zeichnet sich die erfindungsgemäße Pointer-Schaltung durch einfache Möglichkeiten der Initialisierung aus und sie ist eine robuste statische Pointer-Schaltung hoher Geschwindigkeit und geringer Verlustleistung.

Bevorzugte und vorteilhafte Ausgestaltungen der erfindungsgemäßen Pointer-Schaltung gehen aus den Unteransprüchen hervor.

Die Erfindung wird in der nachfolgenden Beschreibung anhand der Figuren beispielhaft näher erläutert. Es zeigen:

Figur 1 ein Blockschaltbild einer ersten Variante einer erfindungsgemäßen Pointer-Schaltung,

Figur 1a das Taktschema für die an die Schaltung nach Figur 1 anzulegenden Schiebetakte, die das Weiterschieben des bestimmten einen logischen Zustands bewirken, auf dem der ausgewählte Ausgang liegt,

Figur 2 ein Blockschaltbild einer zweiten Variante einer erfindungsgemäßen Pointer-Schaltung,

Figur 2a das Taktschema für die an die Schaltung nach Figur 3 anzulegenden Schiebetakte, die das Weiterschieben des bestimmten einen logischen Zustands, auf dem der ausgewählte Ausgang liegt, und die das Zurücksetzen der Speicher bewirken,

Figur 3 ein Blockschaltbild einer dritten Variante einer erfindungsgemäßen Pointer-Schaltung mit spezieller Option der Initialisierung dieser Schaltung,

Figur 3a das Taktschema für die an die Schaltung nach Figur 3 anzulegenden Schiebetakte, die das Weiterschieben des bestimmten einen logischen Zustands, auf dem der ausgewählte Ausgang liegt, und die das Zurücksetzen der Speicher bewirken und über für den Rücksetzvorgang der Speicher verantwortliche Schalter die spezielle Option der Initialisierung dieser Schaltung ermöglichen,

Figur 4 ein Blockschaltbild einer vierten Variante einer erfindungsgemäßen Pointer-Schaltung mit der Besonderheit, daß der Rücksetzvorgang und der Setzvorgang wie bei der zweiten und dritten Variante gemäß Figur 2 und Figur 3 vollständig voneinander entkoppelt sind, jedoch im Gegensatz zur zweiten und dritten Variante nur zwei Taktsignale benötigt werden,

Figur 4a — das Taktschema für die an die Schaltung nach Figur 4 anzulegenden Schiebetakte, die das Weiterschieben des bestimmten einen logischen Zustands, auf dem der ausgewählte Ausgang liegt, bewirken,

Figur 5 — ein Blockschaltbild einer fünften Variante einer erfindungsgemäßen Pointer-Schaltung mit der Besonderheit, daß der Einsatz von Schaltern mit zueinander komplimentärer Steuercharakteristik den Betrieb dieser Schaltung mit nur einem Taktsignal ermöglicht.

Figur 5a — das Taktschema für den an die Schaltung nach Figur 5 anzulegenden Schiebetakt, der das Weiterschieben des bestimmten einen logischen Zustands, auf dem der ausgewählte Ausgang liegt, bewirken,

Figur 6 — ein Blockschaltbild einer sechsten Variante einer erfindungsgemäßen Pointer-Schaltung, die sich als Abwandlung der ersten Variante gemäß Figur 1 unter Zuhilfenahme von Schaltern mit zueinander komplementärer Steuercharakteristik ergibt,

Figur 6a — das Taktschema für die an die Schaltung nach Figur 6 anzulegenden Schiebetakte, die das Weiterschieben des bestimmten einen logischen Zustands, auf dem der ausgewählte Ausgang liegt, bewirken,

Figur 7 — ein Blockschaltbild einer siebten Variante einer erfindungsgemäßen Pointer-Schaltung, die sich als Abwandlung vierten Variante gemäß Figur 4 unter Zuhilfenahme von Schaltern mit zueinander komplementärer Steuercharakteristik ergibt, wobei auch hier der Rücksetzvorgang und der Setzvorgang vollständig voneinander entkoppelt sind und nur zwei Taktsignale benötigt werden,

Figur 7a — das Taktschema für die an die Schaltung nach Figur 7 anzulegenden Schiebetakte, die das Weiterschieben des bestimmten einen logischen Zustands, auf dem der ausgewählte Ausgang liegt, bewirken,.

Figur 8 — eine Ausführung der ersten Variante nach Figur 1 der erfindungsgemäßen Pointer-Schaltung in CMOS-Technologie,

Figur 9 — eine Ausführung der zweiten Variante nach Figur 2 der erfindungsgemäßen Pointer-Schaltung in CMOS-Technologie,

Figur 10 — eine Ausführung der dritten Variante nach Figur 3 der erfindungsgemäßen Pointer-Schaltung in CMOS-Technologie.

Figur 11 — eine Ausführung der fünften Variante nach Figur 5 der erfindungsgemäßen Pointer-Schaltung in CMOS-Technologie

Figur 12 — eine Ausführung der sechsten Variante nach Figur 6 der erfindungsgemäßen Pointer-Schaltung in CMOS-Technologie.

Figur 13 — eine Ausführung der siebten Variante nach Figur 7 der erfindungsgemäßen Pointer-Schaltung in CMOS-Technologie,

Figuren 14a-14d — verschiedene Anordnungen von Schaltern zur Initialisierung einer erfindungsgemäßen Pointer-Schaltung, wobei in Figur 14a Schalter zur Initialisierung zwischen Speicheranschlüssen der Speicher und Bezugspotential $V_{SS}$, in Figur 14b Schalter zur Initialisierung zwischen Speicheranschlüssen der Speicher und einer Versorgungsspannung $V_{DD}$, in Figur 14c Schalter zur Initialisierung zwischen Speicheranschlüssen der Speicher und Bezugspotential $V_{SS}$ und in Figur 14d Schalter zwischen den Speicheranschlüssen der Speicher und der Versorgungsspannung $V_{DD}$ gezeigt sind,

| | |
|---|---|
| Figuren 15a und 15b | schematische Darstellungen zur Initialisierung einer erfindungsgemäßen Pointer-Schaltung über die Zuführung der Versorgungsspannungen, wobei Figur 15a eine Aufsplittung der $V_{SS}$-Zuführung zeigt, bei der normalerweise direkt auf $V_{SS}$-Potential liegende Knoten innerhalb der Speicher in $V_{SS1,Latch}$ und $V_{SS2,Latch}$ aufgeteilt werden, wobei die $V_{SS1,Latch}$-Anschlüsse hingegen an ein (H-aktives) Signal RESET gelegt werden, und Figur 15b eine Aufsplittung der $V_{DD}$-Zuführung zeigt, bei der normalerweise direkt auf $V_{DD}$-Potential liegende Knoten innerhalb der Speicher in $V_{DD1,Latch}$ und $V_{DD2,Latch}$ aufgeteilt werden, wobei die $V_{DD1,Latch}$-Anschlüsse direkt an $V_{DD}$-Potential, die $V_{DD2,Latch}$-Anschlüsse hingegen an das (hier L-aktive) Signal RESET gelegt werden, |
| Figuren 16a und 16b | schaltungstechnische Umsetzungen der Methoden zur Initialisierung gemäß den Figuren 14a und 14d, die im Fall der Figur 16a in einer Hinzufügung eines n-MOS-Rücksetztransistors (eingekreist dargestellt) zu jedem Speicher der erfindungsgemäßen Pointer-Schaltung und im Fall der Figur 16b in einer Hinzufügung eines p-MOS-Rücksetztransistors (eingekreist dargestellt) zu jedem Speicher besteht, |
| Figur 17 | in Schematischer Darstellung das Ausgangssignal einer Pointer-Schaltung zu verschiedenen Zeitpunkten, |
| Figur 18 | eine Auswahl genau einer Speicherzelle innerhalb einer Speichermatrix mit Hilfe eines Spalterpointers und eines Zeilenpointers, |
| Figur 19 | den Aufbau eines herkömmlichen Master-Slave-Schieberegisters mit D-Flipflops, |
| Figur 19b | Beispiel für den Aufbau eines D-Flipflops mit Hilfe von vier NAND-Gattern, |
| Figur 20 | den Aufbau eines herkömmlichen Master-Slave-Schieberegisters mit Hilfe von Latches und zwischen den Latches befindlichen Schaltern, und |
| Figur 21 | ein Beispiel für den Aufbau des Master-Slave-Schieberegisters nach Figur 20 in CMOS-Technologie. |

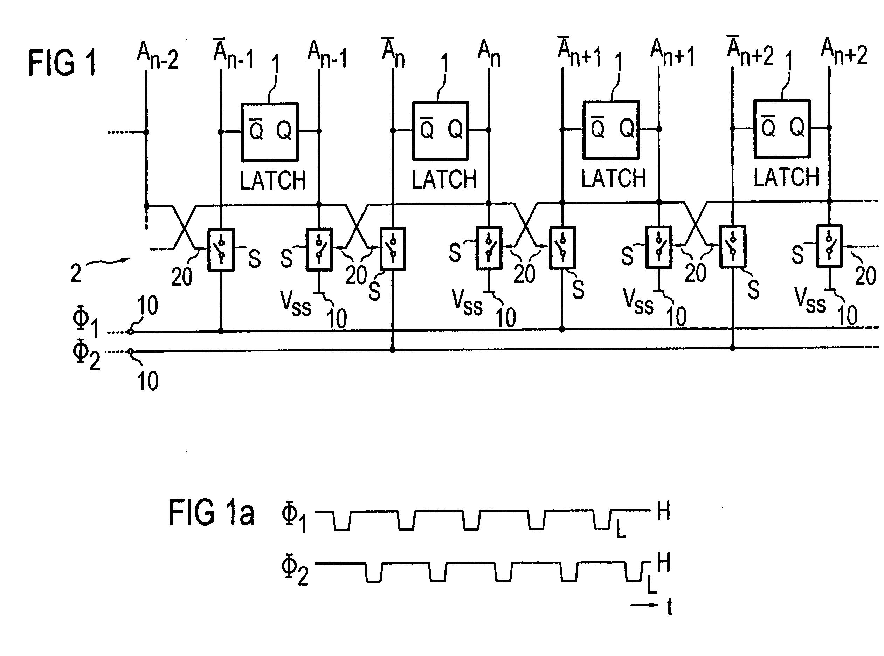

Die erfindungsgemäße Pointer-Schaltung weist unter Bezugnahme auf die Figuren 1 bis 23 eine vorgegebene Anzahl Ausgänge ...$A_{n-2}$, $A_{n-1}$, $A_n$, $A_{n+1}$, $A_{n+2}$... (oder ... $\bar{A}_{n-2}$, $\bar{A}_{n-1}$, $\bar{A}_n$, $\bar{A}_{n+1}$, $\bar{A}_{n+2}$...) auf und dient zum Auswählen eines dieser Ausgänge derart, daß dieser Ausgang als einziger auf einem bestimmten von zwei logisch unterscheidbaren Zuständen liegt, alle übrigen Ausgänge dagegen auf dem anderen logischen Zustand liegen und nicht ausgewählt sind, sowie zum Weiterschieben des einen logische Zustands von dem einen Ausgang zu einem diesem Ausgang nächstbenachbarten Ausgang durch Eingabe eines Schiebetakt-Impulses, so daß nach diesem Weiterschieben der nächstbenachbarte Ausgang auf dem einen logischen Zustand liegt und ausgewählter Ausgang ist, während jalle übrigen Ausgänge einschließlich des einen Ausgangs auf dem anderen logischenZustand liegen und nicht ausgewählt sind.

Die beiden logisch unterscheidbaren Zustände seien mit "1" und "0" bezeichnet und es sei für das folgende ohne Beschränkung der Allgemeinheit angenommen, daß der einen Ausgang auswählende eine logische Zustand im Fall der Ausgänge ...$A_{n-2}$, $A_{n-1}$, $A_n$, $A_{n+1}$, $A_{n+2}$... der Zustand "1" ist.

Für die Ausgänge ... $\bar{A}_{n-2}$, $\bar{A}_{n-1}$, $\bar{A}_n$, $\bar{A}_{n+1}$, $\bar{A}_{n+2}$..., die zu den Ausgängen ...$A_{n-2}$, $A_{n-1}$, $A_n$, $A_{n+1}$, $A_{n+2}$... komplementär sind, bedeutet letzteres, daß der einen Ausgang auswählende logische Zustand der Zustand "0" ist.

Ist beispielsweise $A_n$ ein aus den Ausgängen ...$A_{n-2}$, $A_{n-1}$, $A_n$, $A_{n+1}$, $A_{n+2}$... ausgewählter Ausgang, so bedeutet dies, daß dieser Ausgang auf dem Zustand "1" liegt und alle übrigen Ausgänge ...$A_{n-2}$, $A_{n-1}$, $A_{n+1}$, $A_{n+2}$... auf "0" liegen.

Durch Eingabe eines Schiebetakt-Impulses wird der Zustand "1" vom Ausgang $A_n$ zu einem diesem Ausgang $A_n$ nächstbenachbarten Ausgang $A_{n+1}$ weitergeschoben, so daß nach diesem Schiebetakt der nächstbenachbarte Ausgang $A_{n+1}$ auf dem einen logischen Zustand liegt und ausgewählter Ausgang ist, während jetzt alle übrigen Ausgänge ...$A_{n-2}$, $A_{n-1}$, $A_n$, $A_{n+2}$... einschließlich des einen Ausgangs $A_n$ auf dem anderen Zustand "0" liegen und nicht ausgewählt sind.

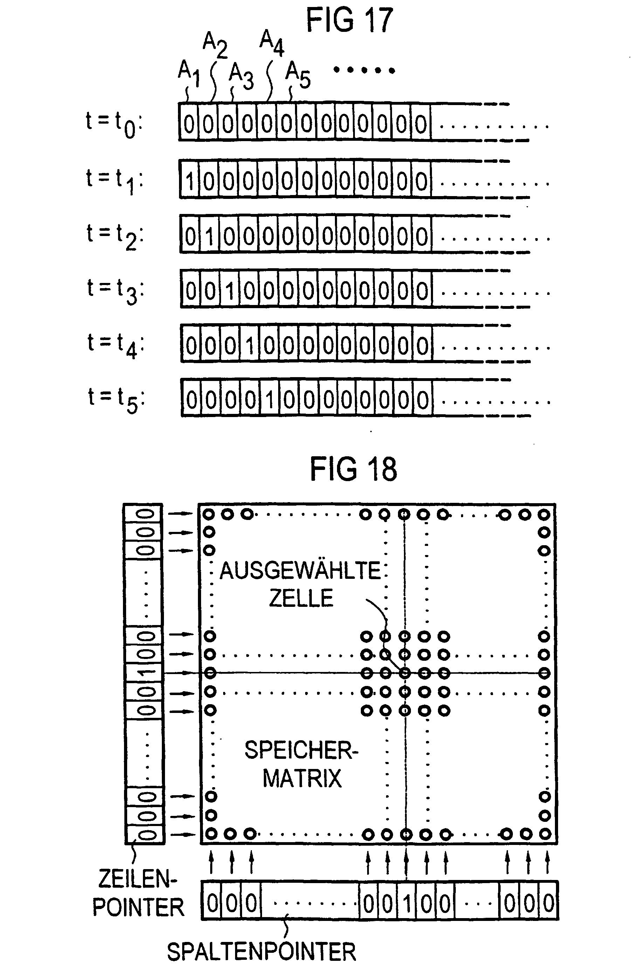

Dieser Zusammenhang ist in Figur 17 graphisch dargestellt, wobei als Ausgangszustand zum Zeitpunkt t = to angenommen ist, daß sich die Pointer-Schaltung im initialisierten, d.h zurückgesetzten Zustand befindet und somit alle Ausgänge ...$A_{n-2}$, $A_{n-1}$, $A_n$, $A_{n+1}$, $A_{n+2}$... auf "0" liegen. Zum nächstfolgenden Taktzeitpunkt t = t1 liegt der erste Ausgang $A_1$ auf "1" und alle übrigen Ausgänge $A_2$, $A_3$, ... auf "0". In allen weiteren dargestellten Zeitpunkten t = $t_i$ (i $\geq$

2) ist in der Figur 17 der Zustand der Schaltung nach Erhalt jeweils eines weiteren Schiebetaktes gezeigt, was jeweils zum Vorrücken des Zustandes "1" um einen Ausgang führt.

Das für die Ausgänge ...$A_{n-2}$, $A_{n-1}$, $A_n$, $A_{n+1}$, $A_{n+2}$...beschriebene gilt für die komplementären Ausgänge ... $\bar{A}_{n-2}$, $\bar{A}_{n-1}$, $\bar{A}_n$, $\bar{A}_{n+1}$, $\bar{A}_{n+2}$... in bezug auf den Zustand "0" analog.

Bei der hier beschriebenen Pointer-Schaltung ist erfindungsgemäß jedem Ausgang ...$A_{n-2}$, $A_{n-1}$, $A_n$, $A_{n+1}$, $A_{n+2}$... (oder... $\bar{A}_{n-2}$, $\bar{A}_{n-1}$, $\bar{A}_n$, $\bar{A}_{n+1}$, $\bar{A}_{n+2}$...) individuell je ein statischer Speicher 1 zugeordnet, deren jeder je ein Paar zueinander komplementärer Speicheranschlüsse Q und $\bar{Q}$ aufweist, derart, daß sich dieses Paar Anschlüsse Q, und $\bar{Q}$ stets auf den zwei voneinander verschiedenen gespeicherten Zuständen "1" und "0" oder "0" und "1" befinden, wobei ein bestimmter Speicheranschluß jedes Speichers 1 mit dem diesem Speicher 1 zugeordneten Ausgang verbunden ist.

Beispielsweise sei im Fall der Anschlüsse ...$A_{n-2}$, $A_{n-1}$, $A_n$, $A_{n+1}$, $A_{n+2}$... der Anschluß Q, im Fall der Anschlüsse ... $\bar{A}_{n-2}$, $\bar{A}_{n-1}$, $\bar{A}_n$, $\bar{A}_{n+1}$, $\bar{A}_{n+2}$... der Anschluß $\bar{Q}$ jedes Speichers 1 mit dem diesem Speicher 1 zugeordneten Anschluß verbunden. Es könnte auch umgekehrt sein. Für das folgende sei ohne Beschränkung der Allgemeinheit der erstgenannte Fall angenommen.

Außerdem ist erfindungsgemäß eine mit dem bestimmten Speicheranschluß Q (oder $\bar{Q}$) jedes Speichers 1 verbundene Schiebeschaltung 2 zum Erzeugen des Zustandes "1" (oder "0") an dem bestimmten Speicheranschluß Q (oder $\bar{Q}$) eines Speichers 1 und zum Weiterschieben des Zustands "1" (oder "0") von dem bestimmten Speicheranschluß Q (oder $\bar{Q}$) eines Speichers "1" (oder "0") zu dem bestimmten Speicheranschluß Q (oder $\bar{Q}$) eines diesem einen Speicher 1 nächstbenachbarten Speichers 1 durch Eingabe wenigstens eines Schiebetakt-Impulses vorgesehen, die zugleich bewirkt, daß mit Ausnahme des jeweiligen Speichers 1, dessen bestimmter Speicheranschluß Q (oder $\bar{Q}$) auf dem Zustand "1" (oder "0") liegt, die bestimmten Speicheranschlüsse Q (oder $\bar{Q}$) aller übrigen Speicher 1 auf dem anderen logischen Zustand "0" (oder "1") liegen.

Die Schiebeschaltung 2 weist vorzugs- und vorteilhafterweise pro Speicher 1 je einen diesem Speicher 1 individuell zugeordneten steuerbaren Schalter S auf, der zwischen den bestimmten Speicheranschluß Q (oder $\bar{Q}$) dieses Speichers 1 und einem Anschluß 10 zum Anlegen eines Potentials geschaltet ist und einen Steuereingang 20 zum Anlegen eines Schaltimpulses zum wahlweisen Schließen und/oder Sperren des Schalters 20 aufweist, und pro Speicher 1 je einen diesem Speicher 1 individuell zugeordneten steuerbaren Schalter S auf, der zwischen den anderen Speicheranschluß $\bar{Q}$ (oder Q) dieses Speichers 1 und einem Anschluß 10 zum Anlegen eines Potentials geschaltet ist und ebenfalls einen Steuereingang 20 zum Anlegen eines Schaltimpulses zum wahlweisen Schließen und/oder Sperren des Schalters 20 aufweist.

Die erfindungsgemäße Pointer-Schaltung mit einer derart ausgebildeten Schiebeschaltung 2 bildet die Grundlage für die in den den Figuren 1 bis 7 dargestellten zahlreichen Ausführungsvarianten der erfindungsgemäßen Pointer-Schaltung.

Für die nachfolgende Erläuterung der Funktionsweise der Schaltungen gemäß den Figuren 1 bis 7 gelte ohne Beschränkung der Allgemeinheit folgende Konvention:

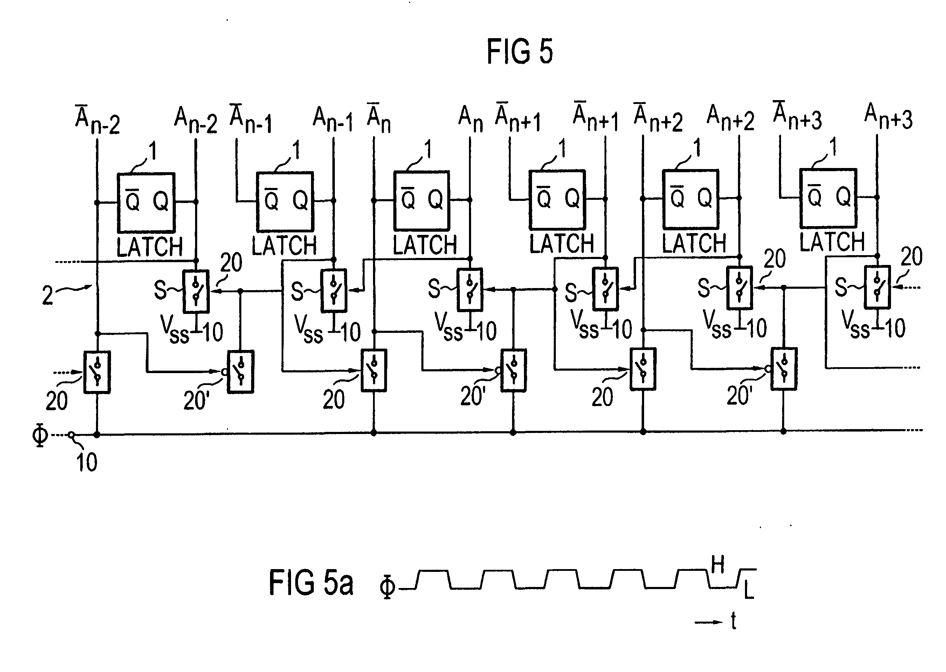

Die Schalter S seien geschlossen, wenn an ihrem Steuereingang 20 der Zustand "1" anliegt. Wenn am Steuereingang 20 "0" anliegt, sollen die Schalter S sperren. Bei den Varianten nach den Figuren 5 bis 7 sind zusätzliche Schalter S' verwendet, die eine zu einem Schalter S genau komplementäre Steuercharakteristik aufweisen, d.h., die zusätzlichen Schalter S' schließen bei Anliegen des Zustandes "0" am Steuereingang 20', während sie bei Anliegen des Zustandes "1" am Steuereingang 20' geöffnet sind und sperren. Diese Schalter S' sind durch einen kleinen Kreis am Steuereingang 20' zusätzlich gekennzeichnet.

Der Zustand "1" entspreche einem hohen Spannungspegel H und der Zustand "0" einem niedrigen Spannungspegel L.

Bei der Pointer-Schaltung nach Figur 1 ist jeder einem Speicher 1 individuell zugeordnete steuerbare Schalter S, der einerseits mit dem bestimmten Speicheranschluß Q dieses Speichers 1 verbunden ist, andererseits mit einem Anschluß 10 zum Anlegen eines Bezugspotentials $V_{SS}$ verbunden.

Außerdem ist jeder einem Speicher 1 individuell zugeordnete steuerbare Schalter S, der einerseits mit dem anderen Speicheranschluß $\bar{Q}$ dieses Speichers 1 verbunden ist, andererseits mit einem Anschluß 10 zum Anlegen eines Taktsignals $\Phi_1$ oder $\Phi_2$ derart verbunden, daß diese Schalter S der Reihe nach abwechselnd mit einem Anschluß 10 zum Anlegen eines Taktsignals $\Phi_1$ oder $\Phi_2$ und mit einem Anschluß 10 zum Anlegen eines anderen Taktsignals $\Phi_2$ oder $\Phi_1$ verbunden sind. Beispielsweise ist der mit dem anderen Speicheranschluß $\bar{Q}$ des dem Ausgang $\bar{A}_{n-1}$ zugeordneten Speicher 1 mit einem Anschluß 10 zum Anlegen des einen Taktsignals $\Phi_1$, der mit dem anderen Speicheranschluß $\bar{Q}$ des diesem Ausgang $\bar{A}_{n-1}$ nächstbenachbarten Ausgang $\bar{A}_n$ zugeordneten Speicher 1 mit einem Anschluß 10 zum Anlegen des anderen Taktsignals $\Phi_2$, der mit dem anderen Speicheranschluß $\bar{Q}$ des diesem Ausgang $\bar{A}_n$ nächstbenachbarten Ausgang $\bar{A}_{n+1}$ zugeordneten Speicher 1 wieder mit einem Anschluß 10 zum Anlegen des einen Taktsignals $\Phi_1$ usw. verbunden.

Überdies ist der bestimmte Speicheranschluß Q eines Speichers 1 mit dem Steuereingang 20 eines diesem Speicher 1 nächstbenachbarten Speichers 1 zugeordneten Schalters S, der mit dem bestimmten Speicheranschluß Q dieses Speichers 1 verbunden ist, und mit dem Steuereingang 20 eines diesem Speicher 1 nächstbenachbarten anderen Speichers 1 zugeordneten Schalters S verbunden, der mit dem anderen Speicheranschluß $\overline{Q}$ dieses Speichers 1 verbunden ist.

Unter der Annahme, daß der bestimmte Speicheranschluß Q des einen Speichers 1 auf "1" und damit auf dem Pegel H liegt, sind entsprechend den oben angenommenen Konvention genau zwei Schalter S, S geschlossen, nämlich der zwischen den betimmten Speicheranschluß Q eines nächstbenachbarten Speichers 1 und den Anschluß 10 zum Anlegen des Bezugspotentials $V_{SS}$ geschaltete Schalter S und der zwischen den anderen Speicheranschluß $\overline{Q}$ des anderen nächstbenachbarten Speichers 1 und den Anschluß 10 zum Anlegen eines Taktsignals $\Phi_1$ oder $\Phi_2$ geschaltete Schalter S.

Liegt beim Beispiel nach Figur 1 beispielsweise der mit dem Ausgang $A_n$ verbundene bestimmte Speicheranschluß Q des diesem Ausgang $A_n$ zugeordneten Speichers 1 auf dem Zustand "1", so sind der zwischen den Ausgang $A_{n+1}$ und das Bezugspotential $V_{SS}$ geschaltete Schalter S und der zwischen den Ausgang $A_{n-1}$ und den Anschluß 10 zum Anlegen des Taktsignals $\Phi_1$ geschaltete Schalter S geschlossen.

Befinden sich die Anschlüsse 10 zum Anlegen der Taktsignale $\Phi_1$ oder $\Phi_2$ beide auf H-Potential, sind alle Schalter S der Pointer-Schaltung, insbesondere auch die beiden geschlossenen, in diesem stromlosen Zustand. Dieser Zustand stellt somit einen statischen Ruhezustand der Schaltung dar. Eine Verschiebung des Zustandes "1" zu einem nächstbenachbarten Ausgang, beispielsweise vom Ausgang $A_n$ zum Ausgang $A_{n+1}$ wird wie folgt erreicht: Durch Absenken des Schiebetaktignals $\Phi_1$ auf L-Pegel wird auch der Ausgang $\overline{A}_{n+1}$ vo H auf L geändert. Entsprechend stellt sich nach kurzer Reaktionszeit des Latches bzw. Speichers 1 am Ausgang $A_{n+1}$ der komplementäre Pegel dazu ein, d.h., der Ausgang $A_{n+1}$ nimmt dann H-Pegel und damit den Zustand "1" an. Dadurch werden die Schalter S geschlossen, die sich zwischen dem Ausgang $\overline{A}_{n+2}$ und dem Anschluß 10 für das Taktsignal $\Phi_2$ und zwischen dem Anschluß $A_n$ und dem Bezugspotential $V_{SS}$ befinden. Somit wird der Anschluß $A_n$ auf L-Potential gezogen, was ein Zurücksetzen des entsprechenden Speichers 1 bewirkt, so daß wieder der Anschluß $A_n$ auf "0" und der komplementäre Anschluß $\overline{A}_n$ auf "1" liegt. Das Taktsignal $\Phi_1$ wird nun wieder auf H-Potential gesetzt. Die Schaltung befindet sich ebenfalls wieder in einem statischen Zustand, der der folgenden Beschreibung entspricht: Der Ausgang $A_{n+1}$ liegt auf dem Zustand "1", alle übrigen Ausgänge ... $A_{n-2}$, $A_{n-1}$, $A_n$, $A_{n+2}$, ... liegen auf dem Zustand "0" . Analog dazu liegt der Ausgang $\overline{A}_{n+1}$ auf dem Zustand "0" und alle übrigen Ausgänge ... $\overline{A}_{n-2}$, $\overline{A}_{n-1}$, $\overline{A}_n$, $\overline{A}_{n+2}$, ... liegen auf dem Zustand "1".

Entsprechend sind nun der Schalter S zwischen dem Ausgang $A_n$ und dem Bezugspotential $V_{SS}$ und der Schalter S zwischen dem Knoten $\overline{A}_{n+2}$ und dem Anschluß 10 für das Taktsignal $\Phi_2$ geschlossen, wobei beide Schalter S, S aufgrund des vorstehenden Zustandes der Ausgänge und der Bedingung, daß sich beide Taktsignale $\Phi_1$ oder $\Phi_2$ auf H-Potential befinden, d.h. $\Phi_1 = \Phi_2 = H$ gilt, stromlos sind.

Ein erneutes Verschieben des Zustandes "1" zum Ausgang $A_{c+2}$ ergibt sich analog, nur muß in diesem Falle das Taktsignal $\Phi_2$ anstelle des Taktsignals $\Phi_1$ abgesenkt werden, um den Setzvorgang im entsprechenden Speicher 1 einzuleiten.

Ein Beispiel für Taktsignale $\Phi_1$ und $\Phi_1$, die zum Betrieb der Schaltung nach Figur 1 verwendet werden können, sind in der Figur 1a in zeitlicher Zuordnung zueinander dargestellt.

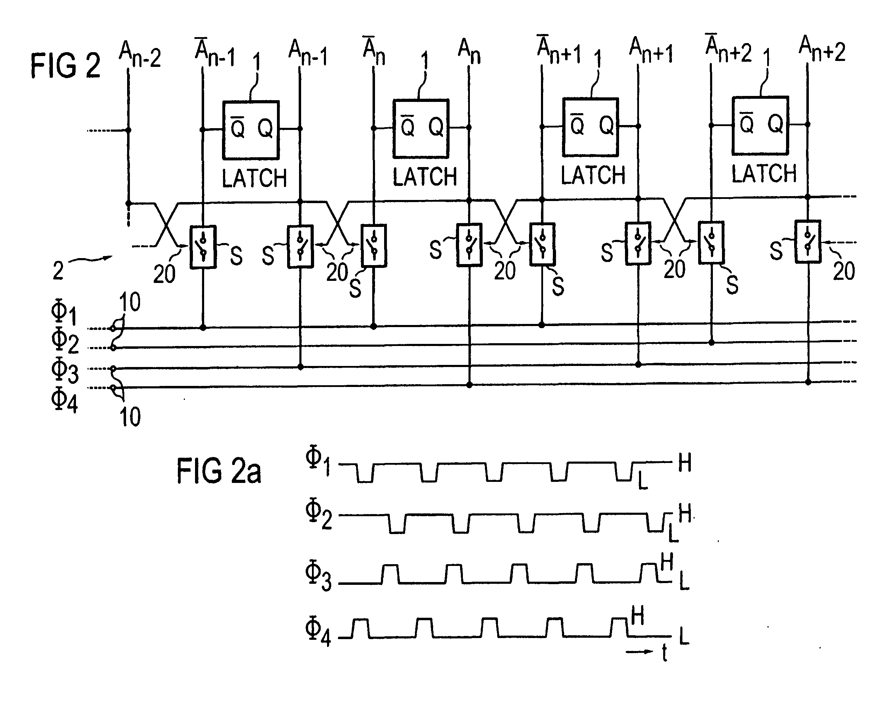

Die Schaltung nach Figur 2 unterscheidet sich von der Schaltung nach Figur 1 lediglich dadurch, daß jeder einem Speicher 1 individuell zugeordnete steuerbare Schalter S, der einerseits mit dem bestimmten Speicheranschluß Q dieses Speichers 1 verbunden ist, andererseits nicht mit dem Bezugspotential $V_{SS}$, sondern mit einem Anschluß 10 zum Anlegen eines Potentials in Form eines weiteren Taktsignals $\Phi_3$ oder $\Phi_4$ derart verbunden, daß diese Schalter S der Reihe nach abwechselnd mit einem Anschluß 10 zum Anlegen eines weiteren Taktsignals $\Phi_3$ oder $\Phi_4$ oder mit einem Anschluß 10 zum Anlegen eines anderen weiteren Schiebetaktes $\Phi_4$ oder $\Phi_3$ verbunden sind. Beispielsweise ist der mit dem bestimmten Speicheranschluß Q des dem Ausgang $A_{n-1}$ zugeordneten Speicher 1 mit einem Anschluß 10 zum Anlegen des weiteren Taktsignals $\Phi_3$, der mit dem bestimmten Speicheranschluß Q des diesem Ausgang $A_{n-1}$ nächstbenachbarten Ausgang $A_n$ zugeordneten Speicher 1 mit einem Anschluß 10 zum Anlegen des anderen weiteren Taktsignals $\Phi_4$, der mit dem anderen Speicheranschluß Q des diesem Ausgang $A_n$ nächstbenachbarten Ausgang $A_{n+1}$ zugeordneten Speicher 1 wieder mit einem Anschluß 10 zum Anlegen des weiteren Taktsignals $\Phi_3$ usw. verbunden.

Der obigen Beschreibung der Funktionsweise der Schaltung nach Figur 1 ist zu entnehmen, daß die Einleitung eines Setzvorgangs eines Speichers 1 automatisch ein Rücksetzen des vorigen Speichers 1 bewirkt, welcher das für den Setzvorgang nötige Signal geliefert hat. Die Funktion dieser Schaltung ist jedoch dadurch gewährleistet, daß alle in ihr befindlichen Speicher 1 und Schalter S eine gewisse Lauf- bzw. Reaktionszeit aufweisen. Somit nimmt der zurückzusetzende Speicher 1 in einer realen Schaltung erst ein wenig später L-Potential an seinem bestimmten Speicheranschluß Q an, nachdem der Setzvorgang des zu setzenden Speichers 1 erfolgt ist.

Durch die Schaltung nach Figur 2 kann der Rücksetzvorgang vorteilhafterweise vollständig vom Ablauf des Setzvorgangs entkoppelt werden, wenn diese mit den der Figur 2a in zeitlicher Zuordnung zueinander dargestellten Taktsignalen $\Phi_1$, $\Phi_2$, $\Phi_3$ und $\Phi_4$ angesteuert wird. Dabei sei vorrausgesetzt, daß sich die Schaltung nach Figur 2 zunächst in einem statischen Zustand befindet, bei dem der Ausgang $A_n$ auf dem Zustand "1" liegt. Dabei befinden sich die Anschlüsse 10 zum Anlegen der Taktsignale $\Phi_1$ und $\Phi_2$ auf dem Potential bzw. Pegel H, die Anschlüsse 10 zum Anlegen der weiteren Taktsignale $\Phi_3$ und $\Phi_4$ dagegen auf dem Potential bzw. Pegel L, d.h. es gilt zu diesem Zeitpunkt $\Phi_1 = \Phi_2 = $ H und $\Phi_3 = \Phi_4 = $ L.

Der Setzvorgang des Ausgangs $A_{n+1}$ erfolgt identisch wie bei der Schaltung nach Figur 1, indem das Taktsignal $\Phi_1$ auf den Pegel L geschaltet wird. Vorher werden bei der Schaltung nach Figur 2 jedoch die Anschlüsse 10 zum Anlegen der weiteren Taktsignale $\Phi_4$ auf hohes Potential H gelegt. Kurz nach dem Wechsel des Datums des Taktsignals $\Phi_1$ vom Pegel H zum Pegel L wird der zwischen den Ausgang $A_n$ und den Anschluß 10 zum Anlegen des weiteren Taktsignals $\Phi_4$ geschaltete Schalter S leitend, da dann der Ausgang $A_{n+1}$ und damit der mit diesem Ausgang $A_{n+1}$ verbundene Steuereingang 20 dieses Schalters S auf dem Zustand "1" und damit dem Pegel H liegt. Da jedoch zu diesem Zeitpunkt auch $A_n = \Phi_4 = $ H gilt, erfolgt noch keine Änderung des Datums von $A_n$. Der Rücksetzungsvorgang am Ausgang $A_n$ auf den Pegel L erfolgt erst dann, wenn das Taktsi-Taktsignal $\Phi_4$ wieder auf den Pegel L abgesenkt wird.

Ein Weiterschieben des Zustandes "1" zum Ausgang $A_{n+2}$ und ein Zurücksetzen des Ausgangs $A_{n+1}$ ergibt sich analog, wenn in der obenstehenden Erläuterung die Taktsignale $\Phi_1$ und $\Phi_4$ gegen die Taktsignale $\Phi_2$ und $\Phi_3$ austauscht.

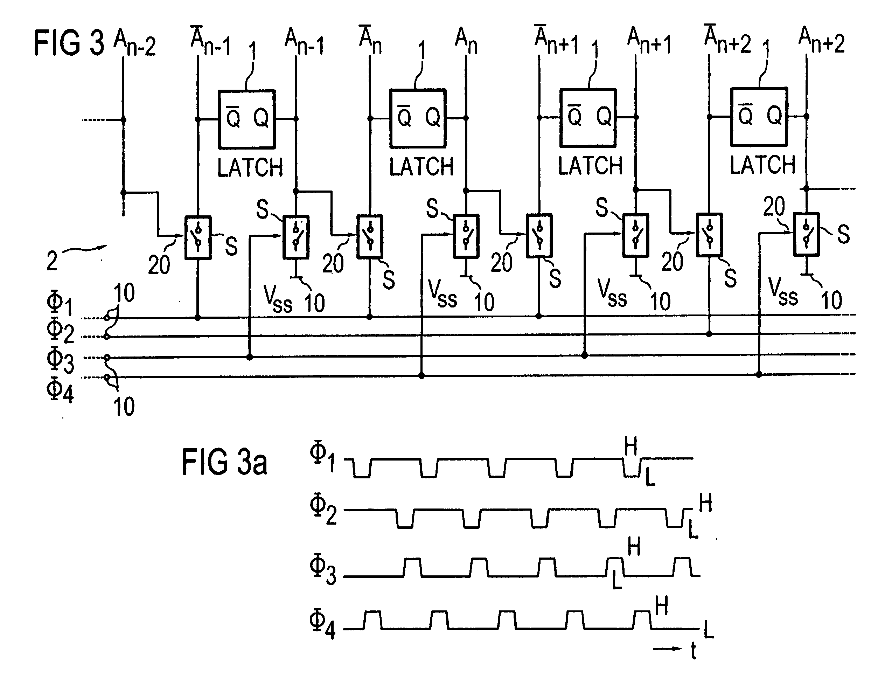

Bei der in Figur 3 dargestellten Schaltung ist jeder einem Speicher 1 individuell zugeordnete steuerbare Schalter S, der einerseits mit dem bestimmten Speicheranschluß Q dieses Speichers 1 verbunden ist, andererseits mit einem Anschluß 10 zum Anlegen eines bestimmten Bezugspotentials $V_{SS}$ verbunden.

Außerdem istjeder einem Speicher 1 individuell zugeordnete steuerbare Schalter S, der einerseits mit dem anderen Speicheranschluß Q dieses Speichers 1 verbunden ist, andererseits mit einem Anschluß 10 zum Anlegen eines Taktsignals $\Phi_1$ oder $\Phi_2$ derart verbunden, daß diese Schalter S der Reihe nach abwechselnd mit einem Anschluß 10 zum Anlegen eines Taktsignals $\Phi_1$ oder $\Phi_2$ und mit einem Anschluß 10 zum Anlegen eines anderen Taktsignals $\Phi_2$ oder $\Phi_1$ verbunden sind. Beispielsweise ist der mit dem anderen Speicheranschluß $\overline{Q}$ des dem Ausgang $\overline{A}_{n-1}$ zugeordneten Speicher 1 mit einem Anschluß 10 zum Anlegen des einen Taktsignals $\Phi_1$, der mit dem anderen Speicheranschluß $\overline{Q}$ des diesem Ausgang $\overline{A}_{n-1}$ nächstbenachbarten Ausgang $\overline{A}_n$ zugeordneten Speicher 1 mit einem Anschluß 10 zum Anlegen des anderen Taktsignals $\Phi_2$, der mit dem anderen Speicheranschluß $\overline{Q}$ des diesem Ausgang $\overline{A}_n$ nächstbenachbarten Ausgang $\overline{A}_{n+1}$ zugeordneten Speicher 1 wieder mit einem Anschluß 10 zum Anlegen des einen Taktsignals $\Phi_1$ usw. verbunden.

Überdies ist der bestimmte Speicheranschluß Q eines Speichers 1 an den Steuereingang 20 eines Schalters S, der einem dem einen Speicher 1 nächstbenachbarten Speicher 1 zugeordnet und mit dem anderen Speicheranschluß $\overline{Q}$ dieses nächstbenachbarten Speichers 1 verbunden ist, angeschlossen.

Die Besonderheit der Schaltung nach Figur 3 besteht darin, daß der Steuereingang 20 eines mit einem bestimmten Speicheranschluß Q eines Speichers 1 verbundene Schalters S mit einem Anschluß 10 zum Anlegen eines weiteren Taktsignals $\Phi_3$ oder $\Phi_4$ derart verbunden, daß die Steuereingänge 20 dieser Schalter S der Reihe nach abwechselnd mit einem Anschluß 10 zum Anlegen eines weiteren Taktsignals $\Phi_3$ oder $\Phi_4$ und mit einem Anschluß 10 zum Anlegen eines anderen weiteren Taktsignals $\Phi_4$ oder $\Phi_3$ verbunden sind. Beispielsweise ist der Steueranschluß 20 des mit dem bestimmten Speicheranschluß Q des dem Ausgang $A_{n-1}$ zugeordneten Speichers 1 mit einem Anschluß 10 zum Anlegen des weiteren Taktsignals $\Phi_3$, der Steueranschluß 20 des mit dem bestimmten Speicheranschluß Q des dem Ausgang $A_n$ zugeordneten Speichers 1 mit einem Anschluß 10 zum Anlegen des anderen weiteren Taktsignals $\Phi_4$, der Steueranschluß 20 des mit dem bestimmten Speicheranschluß Q des dem Ausgang $A_{n+1}$ zugeordneten Speichers 1 wieder mit einem Anschluß 10 zum Anlegen des einen weiteren Taktsignals $\Phi_3$ usw. verbunden.

Auch bei der Schaltung nach Figur 3 ist der Rücksetzvorgang vom Ablauf des Setzvorgangs entkoppelt. Im Gegensatz zur Schaltung nach Figur 2 gelangt das Rücksetzsignal bei der Schaltung nach Figur 3 jedoch nicht nur an den Speicher 1, der sich schaltungstechnisch vor dem zuletzt gesetzten Speicher 1 befindet. Ferner ist bei der Schaltung nach Figur 3 das Rücksetzsignal für einen zwischen einem bestimmten Speicheranschluß Q und dem Bezugspotential $V_{SS}$ angeordneten Schalter S nicht von einem bestimmten Speicheranschluß Q abgeleitet, sondern besteht aus einem weiteren Taktsignal $\Phi_3$ oder $\Phi_4$.

Für eine konkretere Beschreibung der Funktionsweise der Schaltung nach Figur 3 sei wiederum angenommen, daß sich diese Schaltung zunächst in einem statischen Zustand befindet, bei dem der Ausgang An auf dem Zustand "1" liegt, alle übrigen Ausgänge auf dem Zustand "0" liegen. Dabei befinden sich die Anschlüsse 10 zum Anlegen der Taktsignale Φ1 und Φ2 auf dem Potential bzw. Pegel H, die Anschlüsse 10 zum Anlegen der weiteren Taktsignale Φ3 und Φ4 dagegen auf dem Potential bzw. Pegel L, d.h. es gilt zu diesem Zeitpunkt Φ1 = Φ2 = H und Φ3 = Φ4 = L.

Der Setzvorgang des Ausgangs $A_{n+1}$ erfolgt, indem das Schiebeaktsignal $\Phi_1$ auf den Pegel L geschaltet wird. Bei Ansteuerung mit den der Figur 3a in zeitlicher Zuordnung zueinander dargestellten Taktsignalen $\Phi_1$, $\Phi_2$, $\Phi_3$ und $\Phi_4$ werden erst nach Abschluß des Setzvorgangs des zu setzenden Speichers 1 die Anschlüsse 10 zum Anlegen des Taktsignals $\Phi_4$ auf hohes Potential H gelegt wodurch die den Ausgängen $A_{n+2k}$ mit k = 1, 2, 3,... zugeordneten Schalter S diese Ausgänge $A_{n+2k}$ gegen das Bezugspotential $V_{SS}$ kurzschließen. Somit ergibt sich ein Zurücksetzen des Zustandes des Ausgangs $A_n$ auf das Potential L, alle Ausgänge $A_{n+2k}$ liegen bereits vor Schließen der entsprechenden Schalter S auf dem Pegel L. Nach Beendigung des Setzvorgangs des Ausgangs $A_{n+1}$ und des Rücksetzvorgangs des

Ausgangs $A_n$ werden die Taktsignale $\Phi_1$ und $\Phi_4$ wieder auf $\Phi_1 = \Phi_2 = $ H und $\Phi 3 = \Phi 4 = $ L.gelegt.

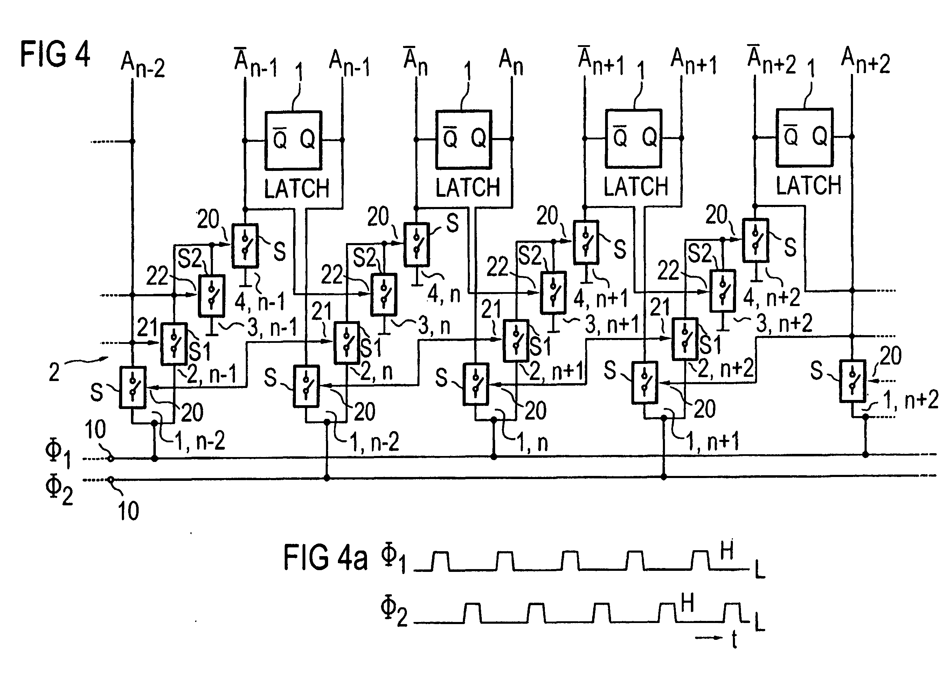

Bei der in Figur 4 dargestellten Schaltung ist jeder einem Speicher 1 individuell zugeordnete steuerbare Schalter S, der einerseits mit dem bestimmten Speicheranschluß Q dieses Speichers 1 verbunden ist, andererseits mit einem Anschluß 10 zum Anlegen eines Taktsignals $\Phi_1$ oder $\Phi_2$ derart verbunden ist, daß alle diese Schalter S der Reihe nach abwechselnd mit einem Anschluß 10 zum Anlegen eines Taktsignals $\Phi_1$ oder $\Phi_2$ und mit einem Anschluß 10 zum Anlegen eines anderen Taktsignals $\Phi_2$ oder $\Phi_1$ verbunden sind. Beispielsweise ist der mit dem bestimmen Speicheranschluß Q des dem Ausgang $A_{n-2}$ zugeordneten Speicher 1 mit einem Anschluß 10 zum Anlegen des einen Taktsignals $\Phi_1$, der mit dem bestimmten Speicheranschluß Q des diesem Ausgang $A_{n-2}$ nächstbenachbarten Ausgang $A_{n-1}$ zugeordneten Speicher 1 mit einem Anschluß 10 zum Anlegen des anderen Taktsignals $\Phi_2$, der mit dem bestimmten Speicheranschluß Q des diesem Ausgang $A_{n-1}$ nächstbenachbarten Ausgang $A_n$ zugeordneten Speicher 1 wieder mit einem Anschluß 10 zum Anlegen des einen Taktsignals $\Phi_1$ usw. verbunden.

Außerdem ist jeder einem Speicher 1 individuell zugeordnete steuerbare Schalter S, der einerseits mit dem anderen Speicheranschluß $\overline{Q}$ dieses Speichers 1 verbunden ist, andererseits mit einem Anschluß 10 zum Anlegen eines bestimmten Bezugspotentials $V_{SS}$ verbunden.

Darüber hinaus ist ein Anschluß 10 zum Anlegen eines Taktsignals $\Phi_1$ oder $\Phi_2$, mit dem ein mit dem bestimmten Speicheranschluß Q eines Speichers 1 verbundener steuerbarer Schalter S verbunden ist, über einen steuerbaren Zwischenschalter S1 mit dem Steueranschluß 20 des mit dem anderen Speicheranschluß $\overline{Q}$ eines dem einen Speicher 1 nächstbenachbarten Speichers 1 verbundenen Schalters S verbunden. Beispielsweise ist der Anschluß 10 zum Anlegen des Taktsignals $\Phi_1$, mit dem der mit dem bestimmten Speicheranschluß Q des dem Ausgang $A_{n-2}$ zugeordneten, nicht dargestellten Speichers 1 verbundene steuerbare Schalter S verbunden ist, über einen steuerbaren Zwischenschalter S1 mit dem Steueranschluß 20 des mit dem anderen Speicheranschluß $\overline{Q}$ des dem nächstbenachbarten Ausgang $A_{n-1}$ zugeordneten Speichers 1 verbundenen Schalters S verbunden, der Anschluß 10 zum Anlegen des Taktsignals $\Phi_2$, mit dem der mit dem bestimmten Speicheranschluß Q des dem Ausgang $A_{n-1}$ zugeordneten Speichers 1 verbundene steuerbare Schalter S verbunden ist, über einen steuerbaren Zwischenschalter S1 mit dem Steueranschluß 20 des mit dem anderen Speicheranschluß $\overline{Q}$ des dem nächstbenachbarten Ausgang $A_n$ zugeordneten Speichers 1 verbundenen Schalters S verbunden, der Anschluß 10 zum Anlegen des Taktsignals $\Phi_1$, mit dem der mit dem bestimmten Speicheranschluß Q des dem Ausgang $A_n$ zugeordneten Speichers 1 verbundene steuerbare Schalter S verbunden ist, über einen steuerbaren Zwischenschalter S1 mit dem Steueranschluß 20 des mit dem anderen Speicheranschluß $\overline{Q}$ des dem nächstbenachbarten Ausgang $A_n$ zugeordneten Speichers 1 verbundenen Schalters S verbunden usw.

Überdies ist der bestimmte Speicheranschluß Q eines Speichers 1 sowohl mit dem Steueranschluß 21 des zwischen den Anschluß 10 zum Anlegen eines Taktsignals $\Phi_1$ oder $\Phi_2$, mit dem der mit dem bestimmten Speicheranschluß Q dieses Speichers 1 verbundene steuerbare Schalter S verbunden ist, und mit dem anderen Speicheranschluß $\overline{Q}$ des dem einen Speicher 1 nächstbenachbarten Speichers 1 geschalteten Zwischenschalter S1 als auch mit dem Steueranschluß 20 des mit dem bestimmten Speicheranschluß Q eines dem einen Speicher 1 nächstbenachbarten anderen Speichers 1 verbundenen Schalters S verbunden. Beispielsweise ist der bestimmte Speicheranschluß Q des dem Ausgang $A_{n-1}$ zugeordneten Speichers 1 sowohl mit dem Steueranschuß 21 des zwischen den Anschluß 10 zum Anlegen eines Taktsignals $\Phi_2$, mit dem der mit dem bestimmten Speicheranschluß Q dieses Speichers 1 verbundene steuerbare Schalter S verbunden ist, und mit dem anderen Speicheranschluß $\overline{Q}$ des dem einen nächstbenachbarten Anschluß $A_n$ zugeordneten Speichers 1 geschalteten Zwischenschalter S1 als auch mit dem Steueranschluß 20 des mit dem bestimmten Speicheranschluß Q dem anderen nächstbenachbarten Anschluß $A_{n-2}$ zugeordneten, nicht dargestellten Speichers 1 verbundenen Schalters S verbunden, der bestimmte Speicheranschluß Q des dem Ausgang $A_n$ zugeordneten Speichers 1 sowohl mit dem Steueranschluß 21 des zwischen den Anschluß 10 zum Anlegen eines Taktsignals $\Phi_1$, mit dem der mit dem bestimmten Speicheranschluß Q dieses Speichers 1 verbundene steuerbare Schalter S verbunden ist, und mit dem anderen Speicheranschluß $\overline{Q}$ des dem einen nächstbenachbarten Anschluß $A_{n+1}$ zugeordneten Speichers 1 geschalteten Zwischenschalter S1 als auch mit dem Steueranschluß 20 des mit dem bestimmten Speicheranschluß Q des dem anderen nächstbenachbarten Anschluß $A_{n-2}$ zugeordneten, nicht dargestellten Speichers 1 verbundenen Schalters S verbunden usw.

Ferner ist bei der Schaltung nach Figur 4 der andere Speicheranschluß $\overline{Q}$ eines Speichers 1 mit einem Steuereingang 22 eines weiteren Zwischenschalters S2 verbunden, der zwischen den Steueranschluß 20 des dem anderen Speicheranschluß $\overline{Q}$ eines diesem Speicher 1 nächstbenachbarten Speicher 1 und dem Bezugspotential $V_{SS}$ geschaltet ist. Beispielsweise ist der andere Speicheranschluß $\overline{Q}$ des dem Ausgang $A_{n-1}$ zugeordneten Speichers 1 mit dem Steuereingang 22 des weiteren Zwischenschalters S2 verbunden, der zwischen den Steueranschluß 20 des dem anderen Speicheranschluß $\overline{Q}$ dem Ausgang $A_n$ zugeordneten Speichers 1 und dem Bezugspotential $V_{SS}$ geschaltet ist, der andere Speicheranschluß $\overline{Q}$ des dem Ausgang $A_n$ zugeordneten Speichers 1 mit dem Steuereingang 22 des weiteren Zwischenschalters S2 verbunden, der zwischen den Steueranschluß 20 des dem anderen Speicheranschluß $\overline{Q}$ des dem Ausgang $A_{n+1}$ zugeordneten Speichers 1 und dem Bezugspotential $V_{SS}$ geschaltet ist, der andere Speicheranschluß $\overline{Q}$ des dem Ausgang $A_{n+1}$ zugeordneten Speichers 1 mit dem Steuereingang 22 des weiteren Zwischenschalters S2 verbunden, der zwischen den Steueranschluß 20 des dem anderen Speicheranschluß $\bar{Q}$ des dem Ausgang $A_{n+1}$ zugeordneten Speichers 1 und dem Bezugspotential $V_{SS}$ geschaltet ist, usw.

Die weiteren Zwischenschalter S2 sind nicht zwingend notwendig, auf sie kann unter ganz bestimmten Umständen, die wiederum von der technologischen Realisierung der mit dem anderen Speicheranschluß $\bar{Q}$ der Speicher 1 abhängen, verzichtet werden.

Bei der Schaltung nach Figur 4 sind der Setzvorgang und der Rücksetzvorgang wieder vollständig voneinander entkoppelt, obwohl im Gegensatz zu den Varianten nach den Figuren 2 und 3 nur zwei Taktsignale $\Phi_1$ und $\Phi_1$ verwendet werden. Dies wird im Prinzip dadurch erreicht, daß der Setzvorgang eines Schalters 1 durch den Pegel H an dem diesem Speicher 1 zugeordneten Anschluß 10 zum Anlegen eines Taktsignals $\Phi_1$ und $\Phi_1$ eingeleitet wird, während der Rücksetzvorgang des vorausgehenden Speichers 1 durch den Pegel L an demselben Anschluß 10 ausgelöst wird. Für die Verwirklichung dieses Prinzips werden jedoch mindestens drei steuerbare Schalter S pro Übergang von einem Speicher 1 zum nächstbenachbarten Speicher 1 statt wie bisher bei den anderen Varianten nur zwei benötigt.

Für eine nähere Erläuterung der Funktionsweise der Schaltung nach Figur 4 sei wiederum angenommen, daß sich diese Schaltung zunächst in einem statischen Zustand befindet, bei dem der Ausgang $A_n$ auf dem Zustand "1" liegt, alle übrigen Ausgänge auf dem Zustand "0" liegen. Dabei befinden sich die Anschlüsse 10 zum Anlegen der Taktsignale $\Phi_1$ und $\Phi_2$ auf dem Potential bzw. Pegel L, d.h. es gilt zu diesem Zeitpunkt $\Phi_1 = \Phi_2 = L$.

In diesem Falle sind der zwischen dem Ausgang $A_n$ und dem Ausgang $A_{n+1}$ angeordnete Zwischenschalter S1 und der mit dem bestimmten Speicheranschluß Q des dem Ausgang $A_{n-1}$ zugeordneten Speichers 1 verbundene Schalter S jeweils geschlossen. Ferner sind alle weiteren Zwischenschalter S2 geschlossen. Alle anderen Schalter S und S1 sind geöffnet. Der zwischen dem Ausgang $A_n$ und dem Ausgang $\bar{A}_{n+1}$ angeordnete Zwischenschalter S1 verbindet somit den Steueranschluß 20 des mit dem anderen Speicheranschluß $\bar{Q}$ des dem Ausgang $\bar{A}_{n+1}$ zugeordneten Speichers 1 mit dem Taktsignal $\Phi_1$. Die Steueranschlüsse 20 der mit den anderen Speicheranschlüssen $\bar{Q}$ der Speicher 1 verbundenen Schalter S werden bei allen Ausgängen mit Ausnahme des Ausgangs $A_{n+1}$ über die weiteren Zwischenschalter S2 mit dem Bezugspotential $V_{SS}$, beispielsweise Masse verbunden. Ferner verbindet der mit dem Ausgang $A_{n-1}$ verbundene Schalter S diesen Ausgang $A_{n-1}$ mit dem Taktsignal $\Phi_1$. Da sich sowohl das Signal $\Phi_1$ wie auch der Ausgang $A_{n-1}$ während des gesamten im folgenden besprochenen Vorgangs des Setzens des Ausgangs $A_{n+1}$ und des Rücksetzens von des Ausgangs $A_n$ auf dem Pegel L befinden, spielt der Zustand des mit dem Ausgang $A_{n-1}$ verbundenen Schalter S in diesem Zusammenhang keine Rolle mehr. Wenn das Taktsignal $\Phi_1$ auf den Pegel H geschaltet wird, schließt der mit dem zum Ausgang $A_{n+1}$ komplentären Ausgang $\bar{A}_{n+1}$ verbundene Schalter S diesen Ausgang $\bar{A}_{n+1}$ gegen das Bezugspotential $V_{SS}$ (Pegel L) kurz, wodurch der logische Zustand am Ausgang $A_{n+1}$ gekippt wird. Solange das Taktsignal $\Phi_1$ auf dem Pegel H bleibt, befindet sich die gesamte Schaltung in dem Zustand, bei dem die Ausgänge $A_n$ und $A_{n+1}$ jeweils auf dem Zustand "1", alle übrigen Ausgänge dagegen auf dem Zustand "0" liegen, d.h. es gilt ...= $A_{n-2} = A_{n-1} = A_{n+1} = A_{n+2} =...=0$ und $A_n = A_{n+1} = 1$.

Zusätzlich zu den bereits geschlossenen Schaltern sind nun auch die mit den bestimmten Speicheranschlüssen Q der Speicher 1 verbundenen Schalter S und die Zwischenschalter S1 geschlossen. Somit ist eine Verbindung des Ausgangs $A_n$ zum Signal $\Phi_1$ hergestellt. Wenn nun das Signal $\Phi_1$ wieder auf den Pegel L abgesenkt wird, wird auch der Ausgang $A_n$ zurückgesetzt.

Ein Weiterschieben des Zustandes "1" zum Ausgang $A_{n+2}$ und ein Zurücksetzen des Ausgangs $A_{n+1}$ ergibt sich analog wie oben beschrieben, wenn nun das Taktsignal $\Phi_2$ anstelle von des Signals $\Phi_1$ einen H-Zyklus durchläuft.

Der vorstehenden Beschreibung ist zu entnehmen, daß die weiteren Zwischenschalter S2 lediglich dazu dienen, die Steueranschlüsse der mit den komplementären Ausgängen ... $\bar{A}_{n-2}$, $\bar{A}_{n-1}$, $\bar{A}_n$, $\bar{A}_{n+1}$, $\bar{A}_{n+2}$ ... verbundenen Schalter S auf ein definietes Potential zu legen, falls diese nicht über einen Zwischenschalter S1 mit einem der Taktsignale $\Phi_1$ oder $\Phi_2$ verbunden werden. Diese Maßnahme ist z.B. dann sinnvoll, wenn die mit den komplementären Ausgängen verbundenen Schalter S aus n-MOS-Transistoren bestehen. In diesem Falle entspricht der Steueranschluß 20 dieser Schalter S dem Gateanschluß der Transistoren, was wiederum bedeutet, daß der Steuereingang dieser Schalter S extrem hochohmig ist. Wären in diesem Falle die weiteren Zwischenschalter S2 nicht vorhanden, könnten z.B. kapazitive Einkopplungen an den Gateknoten dieser Schalter S oder auch Leckströme innerhalb der Schaltung dazu führen, daß an den Gates dieser Schalter S Potentiale auftreten, die zum Leiten dieser Transistoren führen. Dadurch können unbeabsichtigte Schaltvorgänge ausgelöst werden.

Werden die mit den komplementären Ausgängen verbundenen Schalter S hingegen z.B. durch npn-Bipolartransistoren realisiert, so bildet die Basis dieser Transistoren den Steueranschluß der Schalter S, der Emitter liegt beispielsweise auf Bezugspotential, beispielsweise Masse, und der Kollektor am komplementären Speicheranschluß $\bar{Q}$ des Latches bzw. Speichers 1, mit dem dieser Schalter S verbunden ist. In diesem Falle kann auf die weiteren Zwischenschalter S2 verzichtet werden, da die Basis-Emitter-Strecke auch im nichtleitenden Zustand der die mit den komplementären Speicheranschlüssen $\bar{Q}$ verbundenen Schalter S bildenden Transistoren bereits eine vergleichsweise niederohmige Verbindung gegen Masse darstellt, so daß der Einfluß von kapazitiven Einkopplungen oder Leckströmen massiv gemindert wird. Eine Schaltfunktion der mit den komplementären Speicheranschlüssen $\bar{Q}$ verbundenen Schalter S ergibt sich nämlich dann und nur dann, wenn ein gewisser Basisstrom für die diese Schalter S bildenden Transistoren S bereitgestellt wird. Dieses ist jedoch nur dann der Fall, wenn die Basis eines solchen Schalters S über einen geschlossenen Zwischenschalter S1 mit einem Taktsignal $\Phi_1$ oder $\Phi_2$ verbunden wird und dieses Signal $\Phi_1$ oder $\Phi_2$ auf dem Pegel H liegt.

Ein Beispiel für Taktsignale $\Phi_1$ und $\Phi_1$, die zum Betrieb der Schaltung nach Figur 4 verwendet werden können, sind in der Figur 4a in zeitlicher Zuordnung zueinander dargestellt.

Bei der in Figur 5 dargestellten Schaltung ist jeder einem Speicher 1 individuell zugeordnete steuerbare Schalter S, der einerseits mit dem bestimmten Speicheranschluß Q dieses Speichers 1 verbunden ist, andererseits mit einem Anschluß (10) zum Anlegen eines bestimmten Bezugspotentials, z. B. $V_{SS}$, verbunden.

Jedem übernächsten Speicher 1 in der Reihe der Speicher 1 ist je ein steuerbarer Schalter S individuell zugeordnet, der einerseits mit dem anderen Speicheranschluß $\overline{Q}$ dieses übernächsten Speichers 1 verbunden ist, andererseits mit einem Anschluß 10 zum Anlegen eines Taktsignals $\Phi$ verbunden ist.

Außerdem ist der bestimmte Speicheranschluß Q jedes zwischen zwei benachbarten übernächsten Speichern 1 befindlichen Speichers 1 mit dem Steuereingang 20 des mit dem bestimmten Speicherausgang Q eines benachbarten übernächsten Speichers 1 verbundenen Schalters S und dem Steuereingang 20 des mit dem anderen Speicherausgang $\overline{Q}$ des anderen benachbarten übernächsten Speichers 1 verbundenen Schalters S verbunden, und überdies ist zwischen den Steuereingang 20 des mit dem bestimmten Speicherausgang Q jedes übernächsten Speichers 1 verbundenen Schalters S und einen Anschluß 10 zum Anlegen des Taktsignals $\Phi$ je ein zusätzlicher Schalter S' mit je einem Steuereingang 20' zum Anlegen eines Schaltimpulses zum wahlweisen Schließen und/oder Sperren des zusätzlichen Schalters S' und einer zu einem Schalter S komplementären Steuercharakteristik geschaltet, wobei der andere Speicheranschluß $\overline{Q}$ dieses übernächsten Speichers 1 mit dem Steuereingang 20' dieses zusätzlichen Schalters S' verbunden ist.

Beispielsweise sind in der Figur 5 die den Ausgängen ... $A_{n-2}$, $A_n$, $A_{n+2}$ ... zugeordneten Speicher 1 übernächste Speicher, deren anderer Speicheranschluß $\overline{Q}$ mit einem Anschluß 10 zum Anlegen des Taktsignals $\Phi$ verbunden ist. Der andere Speicheranschluß $\overline{Q}$ jedes zwischen zwei benachbarten übernächsten Speichern 1 angeordneten und dem Ausgang $A_{n-1}$, $A_{n+1}$ oder $A_{n+3}$ zugeordneten Speichers 1 ist nur mit dem Ausgang $\overline{A}_{n-1}$, $\overline{A}_{n+1}$ bzw. $\overline{A}_{n+3}$ verbunden. Der bestimmte Speicheranschluß Q des dem Ausgang $A_{n-1}$, $A_{n+1}$ bzw. $A_{n+3}$ zugeordneten Speichers 1 ist mit dem Steuereingang 20 des mit dem bestimmten Speicherausgang Q des benachbarten, dem Ausgang $A_{n-2}$ bzw. $A_n$ bzw. $A_{n+2}$ zugeordneten übernächsten Speichers 1 verbundenen Schalters S und mit dem Steuereingang 20 des mit dem anderen Speicherausgang $\overline{Q}$ des anderen benachbarten, dem Ausgang $A_n$ bzw. $A_{n+2}$ bzw. An+4 (nicht dargestellt) zugeordneten übernächsten Speichers 1 verbundenen Schalters S verbunden usw. Zwischen den Steuereingang 20 des mit dem bestimmten Speicherausgang Q des dem Ausgang $A_{n-2}$, $A_n$ bzw. $A_{n+2}$ zugeordneten übernächsten Speichers 1 verbundenen Schalters S und den Anschluß 10 zum Anlegen des Taktsignals $\Phi$ ist je ein zusätzlicher Schalter S' mit je einem Steuereingang 20' zum Anlegen eines Schaltimpulses zum wahlweisen Schließen und/oder Sperren des zusätzlichen Schalters S' und einer zu einem Schalter S komplementären Steuercharakteristik geschaltet, wobei der andere Speicheranschluß $\overline{Q}$ dieses übernächsten Speichers 1 mit dem Steuereingang 20' dieses zusätzlichen Schalters S' verbunden ist.

Bei der Schaltung nach Figur 5 bewirkt jede Änderung des Taktsignals $\Phi$ ein Weiterschieben des Zustandes "1". Dabei ergibt sich bei einem Wechsel vom Pegel L zum Pegel H eine Übernahme des Zustandes "1" von einem Ausgang $A_{n+k}$ mit ungeradem k, beispielsweise von $A_{n\pm1}$, $A_{n\pm3}$, $A_{n\pm5}$ usw. Im Falle einer Änderung des Signals $\Phi$ vom Pegel H zum Pegel L wird ein Ausgang $A_{n+k}$ mit geradem k auf den Zustand "1" gesetzt. Der Betrieb mit nur einem Taktsignal $\Phi$ wird bei der Schaltung nach Figur 5 also dadurch erreicht, daß beide möglichen Pegelwechsel des Taktsignals $\Phi$ ausgenutzt werden. Die Konsequenz davon ist, daß die einem Speicher 1 nächstbenachbarten Speicher 1 anders als der eine Speicher 1 selbst aufgebaut sein müssen, während die übernächsten Speicher 1 untereinander gleichen Aufbau und alle zwischen jeweils zwei benachbarten übernächsten Speichern 1 angeordneten Speicher 1 untereinander wieder gleichen Aufbau aufweisen.

Im folgenden sei die Funktionsweise der Schaltung nach Figur 5 näher erläutert. Dazu sei wiederum angenommen, daß sich diese Schaltung zunächst in einem statischen Zustand befindet, bei dem der Ausgang $A_n$ auf dem Zustand "1" liegt, alle übrigen Ausgänge auf dem Zustand "0" liegen. Gemäß diesem Ausgangszustand sowie der oben angenommenen Konventionr bzgl. der Eigenschaften der Schalter S und zusätzlichen Schalter S' sind genau zwei Schalter S geschlossen, nämlich der zwischen den Ausgang $A_{n-1}$ und das Bezugspotential $V_{SS}$ geschaltete Schalter S und der zwischen den Ausgang $A_{n+1}$ und das Bezugspotential $V_{SS}$ geschaltete Schalter S. Das Taktsignal $\Phi$ befinde sich auf dem Pegel L. Dementsprechend sind die beiden geschlossenen Schalter S in diesem Zustand stromlos, d.h. die Schaltung befindet sich in einem statischen Ruhezustand. Eine Verschiebung des Zustandes "1" zu dem Ausgang $A_{n+1}$ geschieht durch Änderung des Signals $\Phi$ auf den Pegel H, wobei über den zwischen den Ausgang $A_{n+1}$ und den Anschluß 10 zum Anlegen des Taktsignals $\Phi$ geschalteten zusätzlichen Schalter S', der geschlossenen ist, dieser Ausgang $A_{n+1}$ auf den Pegel H geändert. Des einstellende Pegel H am Ausgang $A_{n+1}$ schließt den zwischen den Ausgang $A_n$ und das Bezugspotential $V_{SS}$ geschalteten Schalter S, d.h. der Ausgang $A_n$ wird auf den Zustand "0" zurückgesetzt. Die Schaltung befindet sich wieder in einem statischen Zustand mit ... = $A_{n-2}$ = $A_{n-1}$ = $A_n$ = $A_{n+2}$ = $A_{n+3}$

=... = "0" und $A_{n+1}$ = "1" und ... = $\bar{A}_{n-2}$ = $\bar{A}_{n-1}$ = $\bar{A}_n$ = $\bar{A}_{n+2}$ = ... = "1" und $\bar{A}_{n+1}$ = "0" sowie $\Phi$ = "1".

Ein erneutes Verschieben des Zustandes "1" zum Ausgang $A_{n+2}$ ergibt sich, wenn das taktsignal $\Phi$ wieder auf den Zustand "0" abgesenkt wird. Dabei geschieht der Setzvorgang der Ausgangs $A_{n+2}$ und der Rücksetzvorgang des Ausgangs $A_{n+1}$ vollkommen analog zu dem Prinzip, welches bei der Schaltung nach Figur 1 verwendetist.

Ein Beispiel für ein Taktsignal $\Phi$, das zum Betrieb der Schaltung nach Figur 5 verwendet werden kann, ist in der Figur 5a im zeitlichen Verlauf dargestellt.

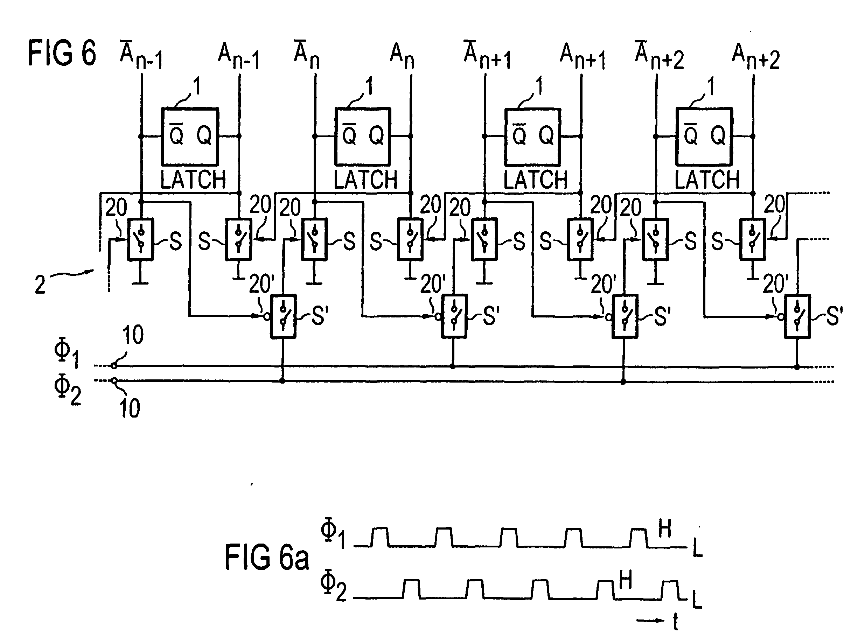

Bei der Schaltung nach Figur 6 ist jeder einem Speicher 1 individuell zugeordnete steuerbare Schalter S, der einerseits mit dem bestimmten Speicheranschluß Q dieses Speichers 1 verbunden ist, andererseits mit einem Anschluß 10 zum Anlegen eines bestimmten Bezugspotentials $V_{SS}$ verbunden und jeder einem Speicher 1 individuell zugeordnete steuerbare Schalter S, der einerseits mit dem anderen Speicheranschluß $\bar{Q}$ dieses Speichers 1 verbunden ist, andererseits mit einem Anschluß 10 zum Anlegen eines bestimmten Bezugspotentials $V_{SS}$ verbunden.

Zwischen den Steuereingang 20 des mit dem anderen Speicherausgang $\bar{Q}$ jedes Speichers 1 verbundenen Schalters S und einen Anschluß 10 zum Anlegen eines Taktsignals $\Phi_1$ oder $\Phi_2$ je ein diesem Speicher 1 zugeordneter zusätzlicher Schalter S' mit je einem Steuereingang 20' zum Anlegen eines Schaltimpulses zum wahlweisen Schließen und/oder Sperren des zusätzlichen Schalters S' und einer zu einem Schalter S komplementären Steuercharakteristik geschaltet ist, derart, daß diese zusätzlichen Schalter S' der Reihe nach abwechselnd mit einem Anschluß 10 zum Anlegen eines Taktsignals $\Phi_1$ oder $\Phi_2$ und mit einem Anschluß 10 zum Anlegen eines anderen Taktsignals $\Phi_2$ bzw. $\Phi_1$ verbunden sind.

Überdies ist der Steuereingang 20' eines einem Speicher 1 zugeordneten zusätzlichen Speichers 1 mit dem anderen Speicheranschluß Q eines diesem Speicher 1 nächstbenachbarten Speichers 1 verbunden.

Beispielsweise ist bei der Schaltung nach Figur 6 der dem Speicher 1 mit dem Ausgang $A_n$ zugeordnete zusätzliche Schalter S' mit dem Anschluß 10 zum Anlegen des Taktsignals $\Phi_2$, der dem Speicher 1 mit dem Ausgang $A_{n+1}$ zugeordnete zusätzliche Schalter S' mit dem Anschluß 10 zum Anlegen des Taktsignals $\Phi_1$, der dem Speicher 1 mit dem Ausgang $A_{n+2}$ zugeordnete zusätzliche Schalter S' mit dem Anschluß 10 zum Anlegen des Taktsignals $\Phi_2$ usw. verbunden. Der Ausgang $\bar{A}_{n-1}$ ist mit dem Steuereingang 20' des dem Speicher 1 mit dem Ausgang $A_n$ zugeordneten zusätzlichen Schalters S', der Ausgang $\bar{A}_n$ ist mit dem Steuereingang 20' des dem Speicher 1 mit dem Ausgang $A_{n+1}$ zugeordneten zusätzlichen Schalters S', der Ausgang $\bar{A}_{n+1}$ ist mit dem Steuereingang 20' des dem Speicher 1 mit dem Ausgang $A_{n+2}$ zugeordneten zusätzlichen Schalters S' usw. verbunden.

Zur Erläuterung der Funktionsweise der Schaltung nach Figur 6 sei wiederum angenommen, daß sich diese Schaltung zunächst in einem statischen Zustand befindet, bei dem der Ausgang $A_n$ auf dem Zustand "1" liegt, alle übrigen Ausgänge auf dem Zustand "0" liegen. Bei dieser Ausgangssituation sind bei einem Zeitpunkt, bei dem die Taktsignale $\Phi_1$ und $\Phi_2$ beide auf dem Pegel L liegen, der Schalter S, der den Ausgang $A_{n-1}$ mit dem Bezugspotential $V_{SS}$ verbindet, und der zusätzliche Schalter S', der den Steuereingang 20 des Schalters S zwischen dem Ausgang $A_{n+1}$ und dem Bezugspotential $V_{SS}$ mit dem Anschluß 10 zum Anlegen des Taktsignals $\Phi_1$ verbindet, geschlossen. Die Schaltung befindet sich in einem statischen Ruhezustand.

Eine Verschiebung der des Zustandes "1" zum den Ausgang $A_{n+1}$ wird erreicht, wenn das Signal $\Phi_1$ den Pegel H annimmt. Dadurch schließt der Schalter S zwischen dem Ausgang $\bar{A}_{n+1}$ und dem Bezugspotential $V_{SS}$, worauf der Anschluß $\bar{A}_{n+1}$ den Pegel L annimmt. Entsprechend ändert sich das Datum des Ausgangs $A_{n+1}$ auf den Pegel H, wodurch wiederum der Schalter S, der zwischen dem Ausgang $A_n$ und dem Bezugspotential $V_{SS}$ liegt, geschlossen wird. Dies wiederum bewirkt das Rücksetzen des Ausgangs $A_n$. Nach Beendigung des Vorgangs der Verschiebung des Zustandes "1" zu dem Ausgang $A_{n+1}$ wird das Signal $\Phi_1$ wieder auf den Pegel L abgesenkt.

Ein erneutes Verschieben der des Zustandes "1" zum Ausgang $A_{n+2}$ ergibt sich analog, nur erfolgt in diesem Falle die Einleitung des Schiebevorgangs durch Aktivierung über das Taktsignal $\Phi_2$ anstelle des Taktsignals $\Phi_1$.

Ein Beispiel für Taktsignale $\Phi_1$ und $\Phi_1$, die zum Betrieb der Schaltung nach Figur 6 verwendet werden können, sind in der Figur 6a in zeitlicher Zuordnung zueinander dargestellt.

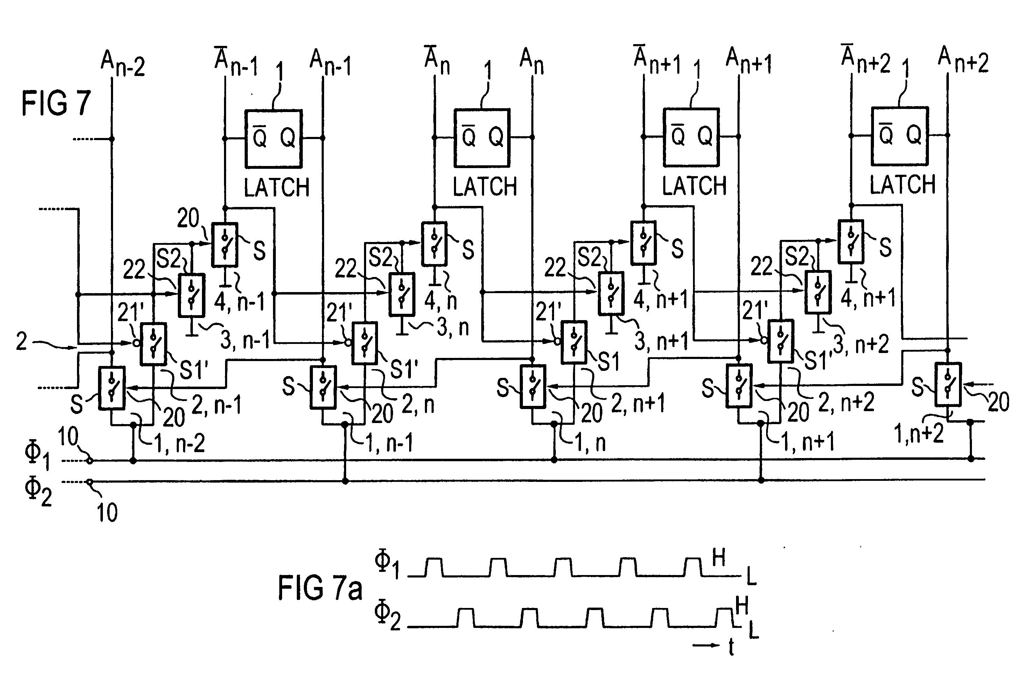

Die Schaltung nach Figur 7 ist eine geringfügige Abwandlung der Schaltung nach Figur 4 dahingehend, daß bei der Schaltung nach Figur 7 jeder mit S1' bezeichnete Zwischenschalter eine zu einem Schalter S komplementäre Steuercharakteristik aufweist. Entsprechend werden die Steuereingänge 21' dieser Zwischenschalter S1' mit Signalen angesteuert, die zu den Signalen, mit denen die Zwischenschalter S1 der Schaltung nach Figur 4 angesteuert werden, komplementär sind. Somit wird für die Schaltung nach Figur 7 hinsichtlich des Funktionsprinzips eine vollkommene Analogie zu der Schaltung nach Figur 4 erhalten. Eine detailliertere Beschreibung erübrigt sich demnach. Insbesondere gelten hier auch die Ausführungen bezüglich der Funktion und der Notwendigkeit der weiteren Zwischenschalter.

Ein Beispiel für Taktsignale $\Phi_1$ und $\Phi_1$, die zum Betrieb der Schaltung nach Figur 7 verwendet werden können, sind in der Figur 7a in zeitlicher Zuordnung zueinander dargestellt. Diese Signale können mit den Signalen nach Figur 4a identisch sein.

Bei Inbetriebnahme einer erfindungsgemäßen Pointer-Schaltung ist es erforderlich, zunächst die gesamte Schaltung zu initialisieren, d.h., alle Ausgänge $A_j$, j = ... n-2, n-1, n, n+1, n+2, n+3,... auf den Zustand "0" zurückzusetzen. Möglicherweise kann ein solcher Rücksetzvorgang auch während des Betriebes optional erwünscht sein. Im folgenden werden verschiedene Möglichkeiten für die Initialisierung beschrieben.

Bei der Schaltung nach Figur 3 kann die Initialisierung vorteilhafterweise durch Anlegen einer bestimmten Kombination aus den Taktsignalen $\Phi_1$, $\Phi_2$, $\Phi_3$ und $\Phi_4$ an die Anschlüsse 10 erreicht werden. Bei dieser Kombination müssen zum Zeitpunkt der Initialisierung die Taktsignale $\Phi_1$, $\Phi_2$, $\Phi_3$ und $\Phi_4$ lediglich jeweils den Pegel H annehmen, so daß zu diesem Zeitpunkt $\Phi_1 = \Phi_2 = \Phi_3 = \Phi_4 = H$ gilt. Bei allen anderen dargestellten Schaltungen besteht eine solche Möglichkeit jedoch nicht.

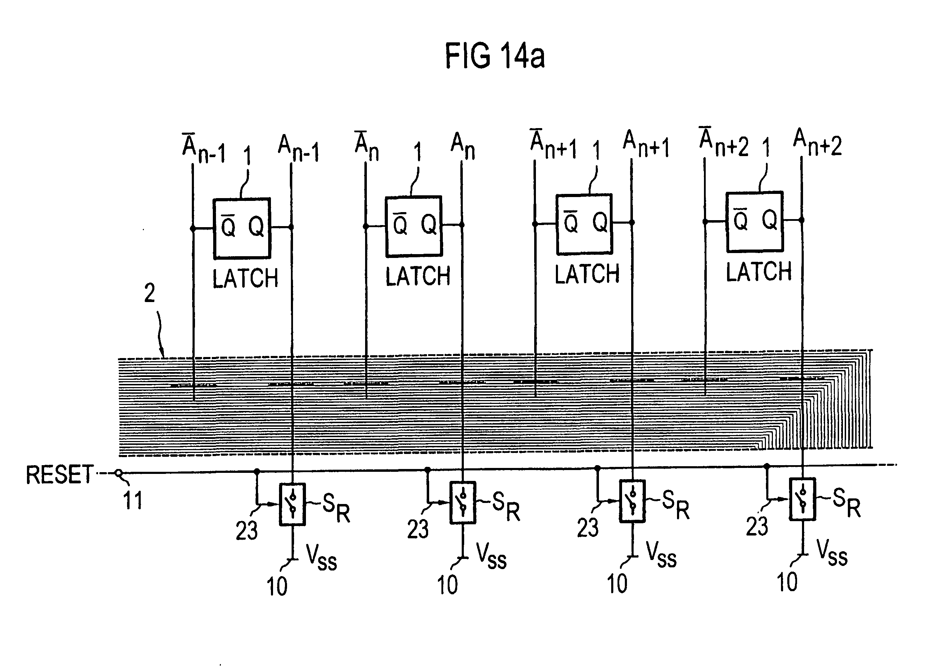

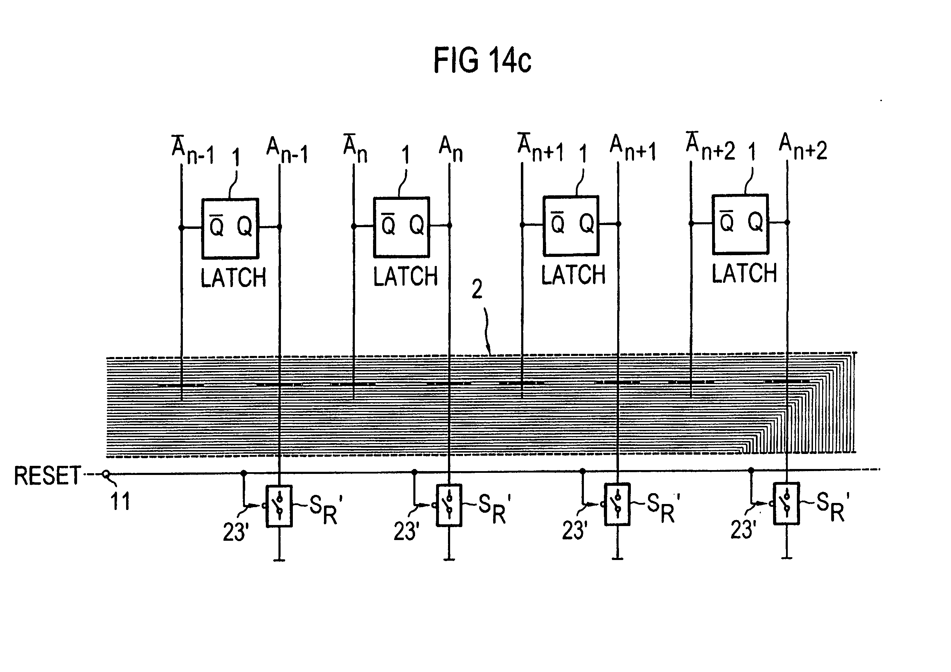

Eine Möglichkeit zur Initialisierung der erfindungsgemäßen Pointer-Schaltung wird geschaffen, wenn zu jedem Speicher 1 der Schaltung zusätzlich zur Schiebeschaltung 2 je ein weiterer Schalter hinzugefügt wird. In den Figuren 14a bis 14d sind verschiedene Varianten dieser Möglichkeit dargestellt, wobei der weitere Schalter mit $S_R$ bezeichnet ist und die Pointer-Schaltung vereinfacht als Blockschaltbild, bestehend aus den Speichern 1 und der Schiebeschaltung 2, dargestellt ist.

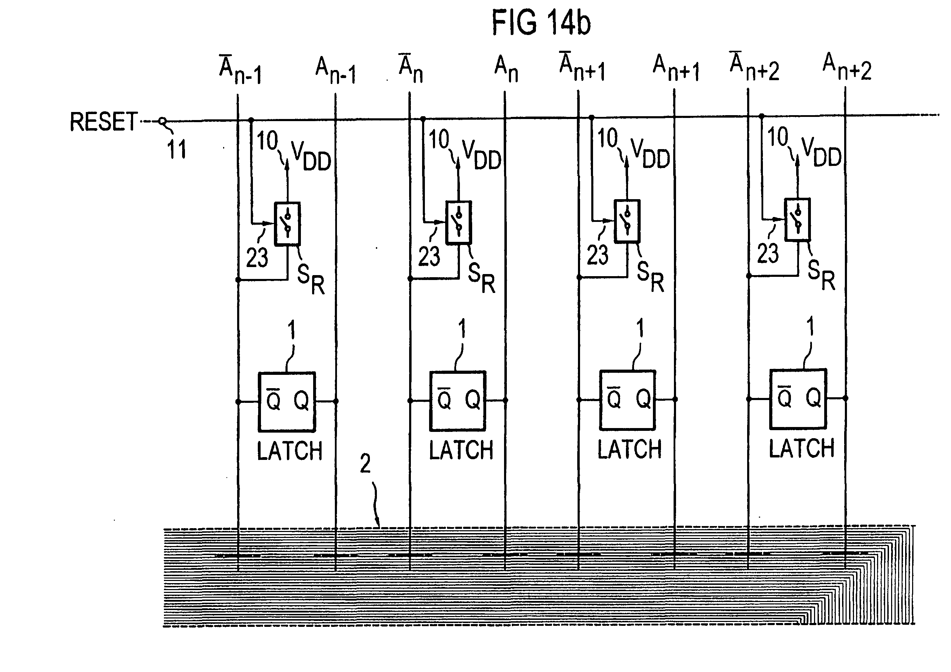

Bei der Variante nach Figur 14a liegen die neu eingefügten weiteren Schalter $S_R$ zwischen den Ausgängen $A_j$, j = ... n-1, n, n+1, ... und dem Bezugspotential $V_{SS}$, bei der Variante nach Figur 14b zwischen den Ausgängen $\bar{A}_j$ und einer Versorgungsspannung $V_{DD}$ für die Pointer-Schaltung.

Jeder weitere Schalter $S_R$ weist einen Steuereingang 23 auf, der mit einem Anschluß 11 zum Anlegen eines Rückstzsignals RESET verbunden ist. Ein Rücksetzen aller Speicher 1 ergibt sich bei den Varianten nach den Figuren 14a und 14b, wenn das Signal RESET den Pegel H annimmt.

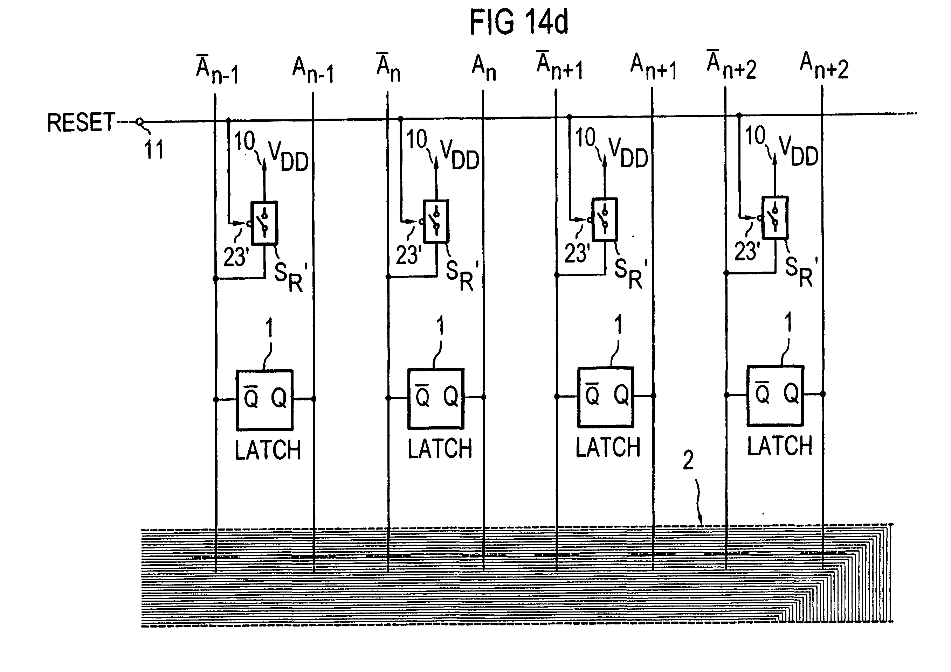

Alternativ können auch weitere Schalter $S_R'$ mit zu den weiteren Schaltern $S_R$ komplementärer Steuercharakteristik verwendet werden, wie in den Figuren 14c und 14d gezeigt ist. In diesem Falle ist das Signal RESET jedoch beim Pegel L aktiv.

Die Steuereingänge dieser weiteren Schalter $S_R'$ sind mit 23' bezeichnet.

Unter gewissen Voraussetzungen kann eine Initialisierung auch über die Zuführung der Versorgungsspannungen $V_{DD}$ vorgenommen werden. In diesem Fall bleibt die Anzahl der weiteren Schalter $S_R$ pro Speicher 1 unverändert, jedoch müssen mehrere getrennte Leitungen für die Zuführung der Versorgungsspannung $V_{DD}$ zu den Bauelementen innerhalb der Speicher 1 verwendet werden. Die Taktsignale liegen während der Initialisierung jeweils auf dem Pegel, den sie auch während der statischen Zustände der entsprechenden Schaltungen einnehmen.

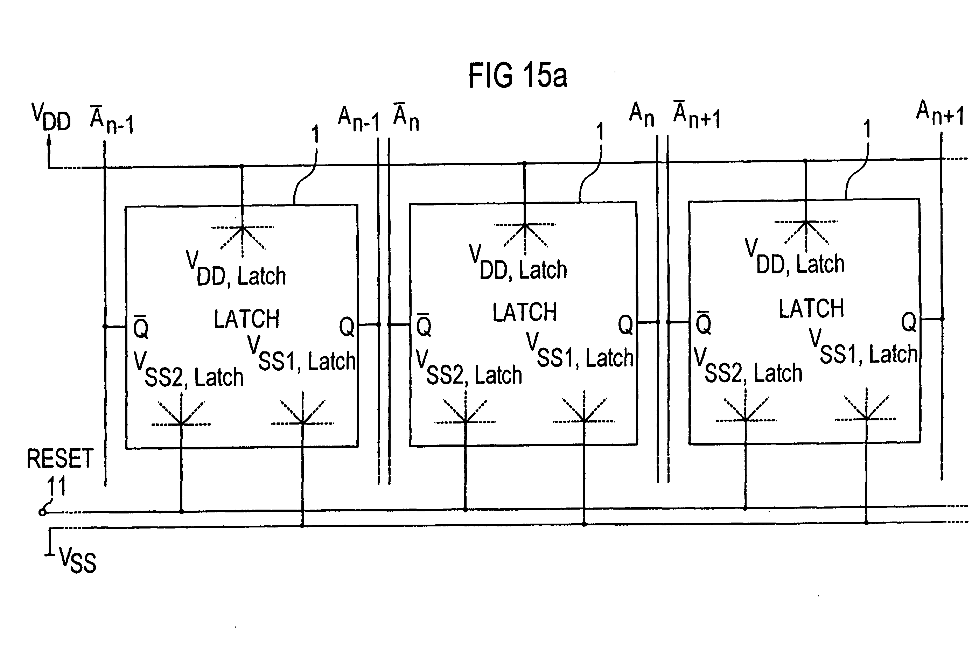

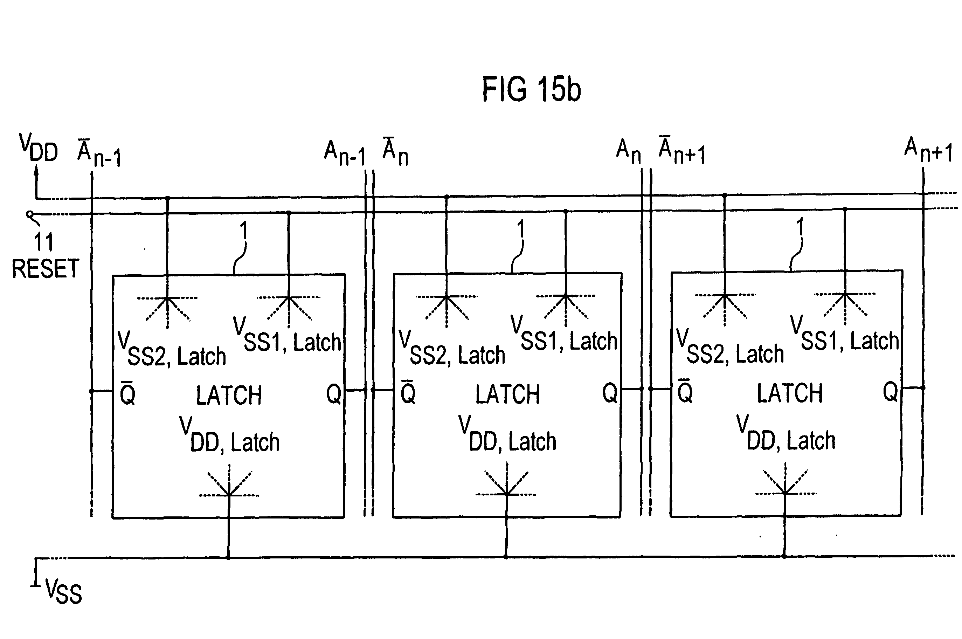

In den Figuren 15a und 15b ist das Verfahren grundsätzlich skizziert. Die Anschlüsse der Bauelemente innerhalb eines Speichers 1, die während des Normalbetriebes am Bezugspotential $V_{SS}$ im Fall der Figur 15a bzw. der Versorgungsspannung $V_{DD}$ im Fall der Figur 15b liegen, werden auf zwei Knoten $V_{SS1,Latch}$ und $V_{SS,Latch}$ (Figur 15a) bzw. $V_{DD1,Latch}$ und $V_{DD2,Latch}$ (Figur 15b)) pro Speicher 1 aufgeteilt. Somit existieren pro Speicher 1 nun drei statt wie üblicherweise zwei Knoten zur Zuführung der Versorgungsspannungen $V_{DD}$. Derjenige Knoten zur Zuführung der Versorgungsspannungen, welcher nur einfach existiert - in Figur 15a der Knoten $V_{DD,Latch}$, in Figur 15b der Knoten $V_{SS,Latch}$ - wird direkt fest an das Potential gelegt, auf welchem er sich auch während des Normalbetriebes befindet. Das gleiche gilt für einen der zweifach ausgeführten Knoten zur Zuführung der Versorgungsspannungen. In den Figuren 15a und 15b wurde ohne Beschränkung der Allgemeinheit jeweils der mit "1" indizierte Anschluß dazu verwendet. An den noch verbleibenden Knoten zur Zuführung der Versorgungsspannungen wird direkt das Signal RESET gelegt.

Während des Normalbetriebes muß das Signal RESET bei der Variante nach Figur 15a auf dem Bezugspotential $V_{SS}$ liegen, bei der Variante nach Figur 15b auf dem Potential $V_{DD}$. Eine Initialisierung der Schaltung nach Figur 15a wird durch Anlegen eines Potentials $V_{DD}$, eine Initialisierung der Schaltung nach Figur 15b durch Anlegen eines Potentials $V_{SS}$ am Anschluß 11 zum Anlegen des Signals RESET erreicht. Nach Zurückschalten des am Anschluß 11 für das Signal RESET auf das für Normalbetrieb gültige Potential liegt an allen Ausgängen $A_j$ sowohl bei der Variante nach Figur 15a als auch der nach 15b der Pegel L an.

Die Anwendbarkeit dieser Methode und die Wahl, welche der Versorgungsspannungen "gesplittet" zugeführt wird, hängt vom konkreten schaltungstechnischen Aufbau der Speicher 1 und von der Höhe der Versorgungsspannung ab. Aus diesem Grunde können diese Fragen nur bei Vorliegen eines konkreten Schaltungsentwurfes entschieden werden. Dieses Verfahren ist im übrigen nicht auf Pointer-Schaltungen beschränkt. Vielmehr kann es für eine weit größere Anzahl von Schaltungen verwendet werden, in welchen statische Speicher bzw. Latches zur Anwendung kommen.

Unabhängig von der Länge, d.h. der Anzahl der Speicher 1 der erfindungsgemäßen Pointer-Schaltung bewirkt ein vollständiger Vorgang zum Verschieben des einen logischen Zustandes, im Beispiel des Zustandes "1", nur in genau zwei Speichern 1 Umladevorgänge, denn Umladevorgänge finden nur in den Speichern statt, deren Ausgangsdatum sich ändert, d.h., im Speicher 1 der den Zustand "1" von einem vorhergehenden Speicher 1 übernimmt, sowie im vorhergehenden Speicher 1. In allen anderen Speichern 1 treten während eines Verschiebevorgangs keine Umladevorgänge an den Ausgängen auf. Diese Konfiguration führt grundsätzlich zu einer sehr günstigen Verlustleistungsbilanz einer erfindungsgemäßen Pointer-Schaltung.

Grundsätzlich sei betont, daß die oben angenommenen Konventionen keine notwendigen Voraussetzungen für das Funktionieren einer erfindungsgemäßen Pointer-Schaltung darstellen. Vielmehr sind auch Varianten dieser Schaltung möglich, bei denen eine andere Zuordnung der logischen Zustände "0" und "1" zu Spannungspegeln vorgenommen wird und bei denen das Setzen bzw. Rücksetzen der Speicher 1 nicht über den Pegel L, sondern über den Pegel H erfolgt. Entsprechend können in diesen Fällen hinsichtlich der Pegel andere Taktschemata erforderlich sein, wobei deren zeitliches Raster jedoch immer gleich bleibt. Ebenfalls kann es in diesen Fällen notwendig sein, die Schalter, die bei den Varianten nach den Figuren 1 bis 7 einen Ausgang oder Anschluß gegen ein Potential $V_{SS}$ oder ein Potential $V_{DD}$ kurzschließen, durch Schalter zu ersetzen, die den entsprechenden Ausgang oder Anschluß gegen ein Potential $V_{DD}$ bzw. Potential $V_{SS}$ verbinden können, oder aber H-aktive Schalter durch L-aktive zu ersetzen und umgekehrt.

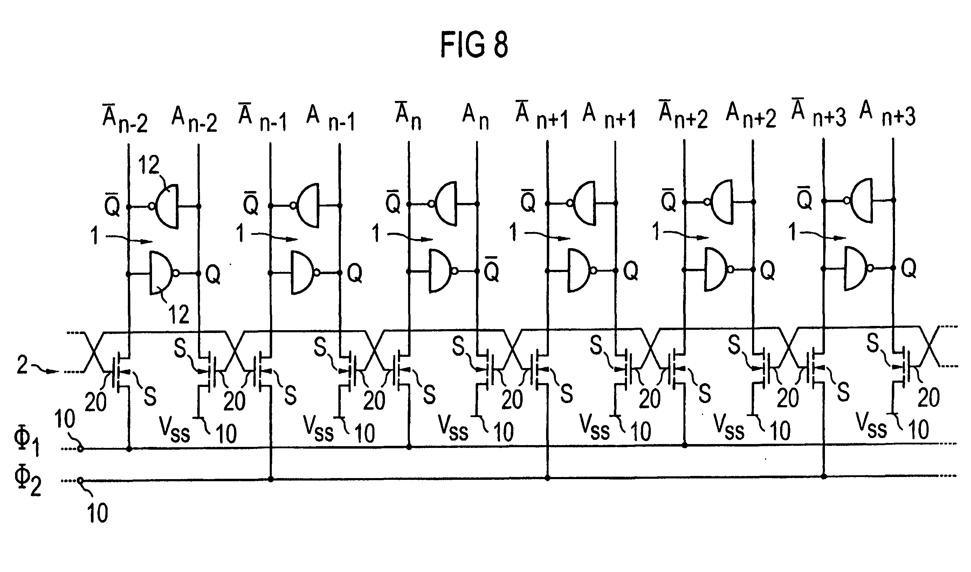

Die Figuren 8 bis 13 zeigen jeweils eine konkrete Realisierung der Schaltungen nach den Figuren 1 bis 3 und 5 bis 7 in CMOS-Techologie.

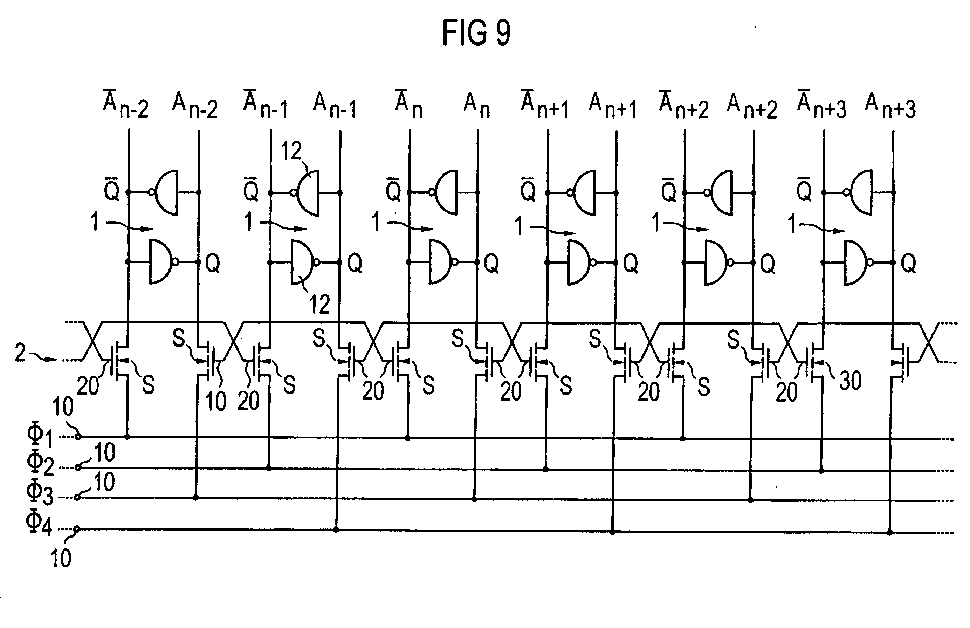

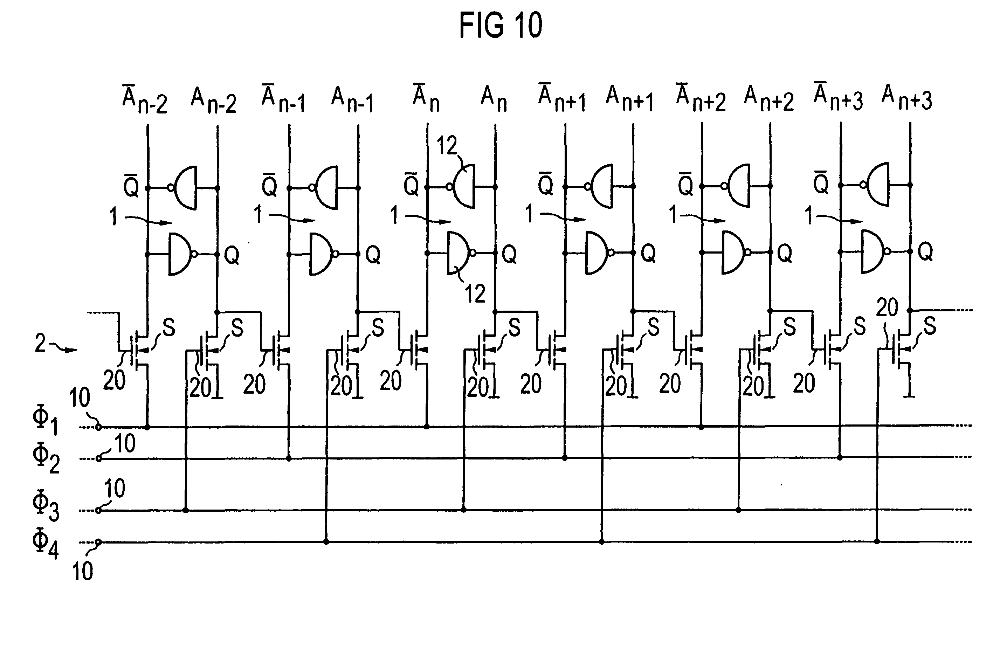

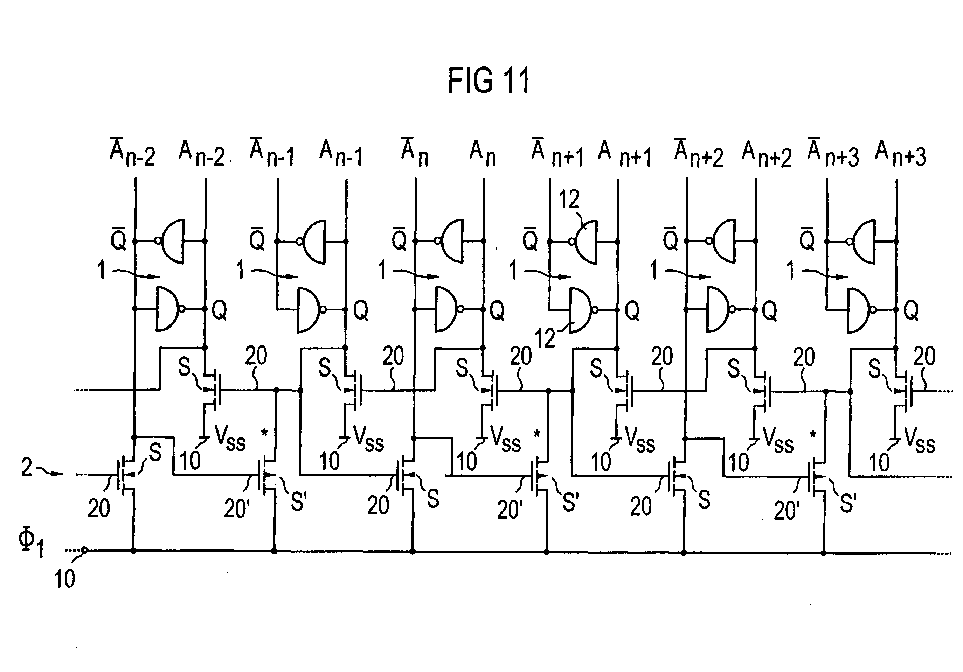

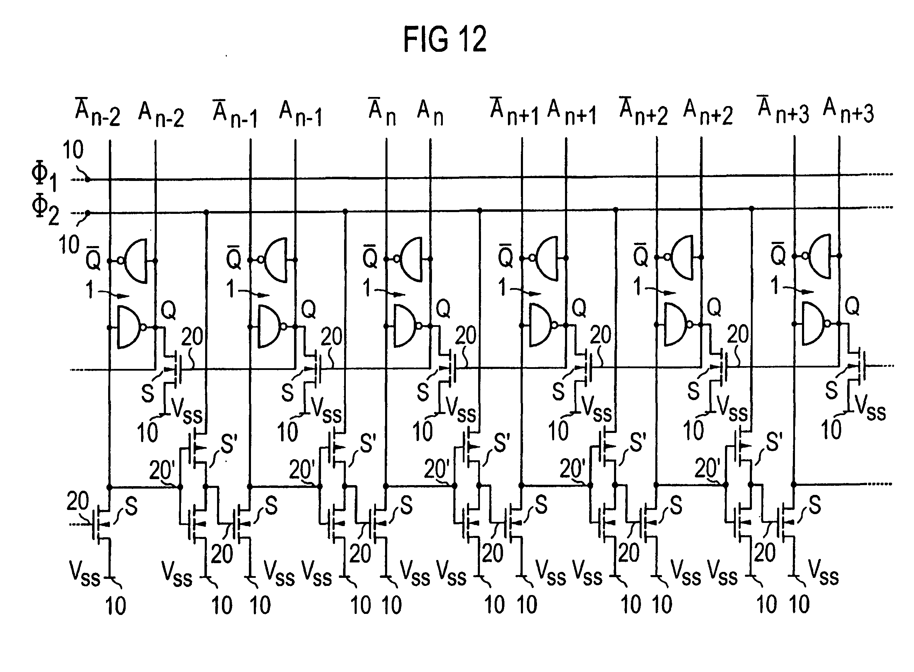

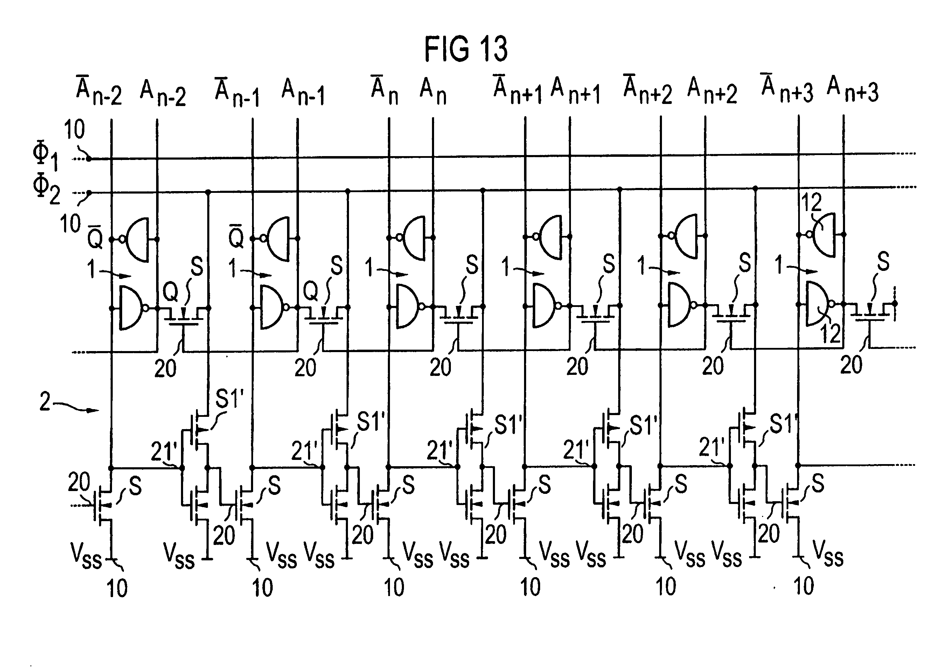

Es zeigen: Figur 8 die Realisierung der Schaltung nach Figur 1, Figur 9 die Realisierung der Schaltung nach Figur 2, Figur 10 die Realisierung der Schaltung nach Figur 3, Figur 11 die Realisierung der Schaltung nach Figur 5, Figur 12 die Realisierung der Schaltung nach Figur 6 und Figur 13 die Realisierung der Schaltung nach Figur 7.

In allen Fällen besteht jeder Speicher 1 aus zwei mitgekoppelten Invertern 12, die Schalter S und Zwischenschenschalter S1, S2 sind durch n-MOS-Transistoren, die weiteren Schalter S' und Zwischenschalter S1' durch p-MOS-Transistoren realisiert, wobei die Gateanschlüsse der Transistoren die Steueranschlüsse 20 ,21 bzw. 22 der Schalter S, S1 bzw. S2 und die Steueranschlüsse der Schalter S' und S1' bilden.

Alle Transistoren, außer die mit einem Sternchen (*) gekennzeichneten p-MOS-Transistoren in Figur 11, haben Minimalabmessungen, wodurch der Platzbedarf der Schaltungen sehr gering ist. Da die Stromtreibfähigkeit von n-MOS-Transistoren um den Faktor 2 bis 3 besser ist als die von p-MOS-Transistoren und da n-MOS-Transistoren ein Potential L ohne Spannungsverlust durchschalten können, garantiert diese Dimensionierung, daß ein auf Potential H liegender Ausgang bzw. Speicheranschluß eines Speichers 1 durch Kurzschließen gegen das Potential L über einen n-MOS-Transistor sicher gekippt werden kann.

Bei der Realisierung nach Figur 11 hingegen erfolgt das Setzen jedes übernächsten Speichers 1 dadurch, daß die betreffenden Speicheranschlüsse dieser Speicher 1 über die mit * gekennzeichneten p-MOS-Transistoren gegen das Potential H geschaltet werden. Diese Transistoren dürfen jedoch nicht minimale Abmessungen haben, da sie das durch einen (minimalen) n-MOS-Transistor gehaltene Potential L am Speicheranschluß des Speichers 1 sicher kippen können müssen und da ihre Stromtreibfähigkeit bei gleichen Abmessungen geringer ist als die von n-MOS-Transistoren. Aus diesem Grunde wurden diese p-MOS-Transistoren fünfmal weiter ausgelegt als die anderen Transistoren.

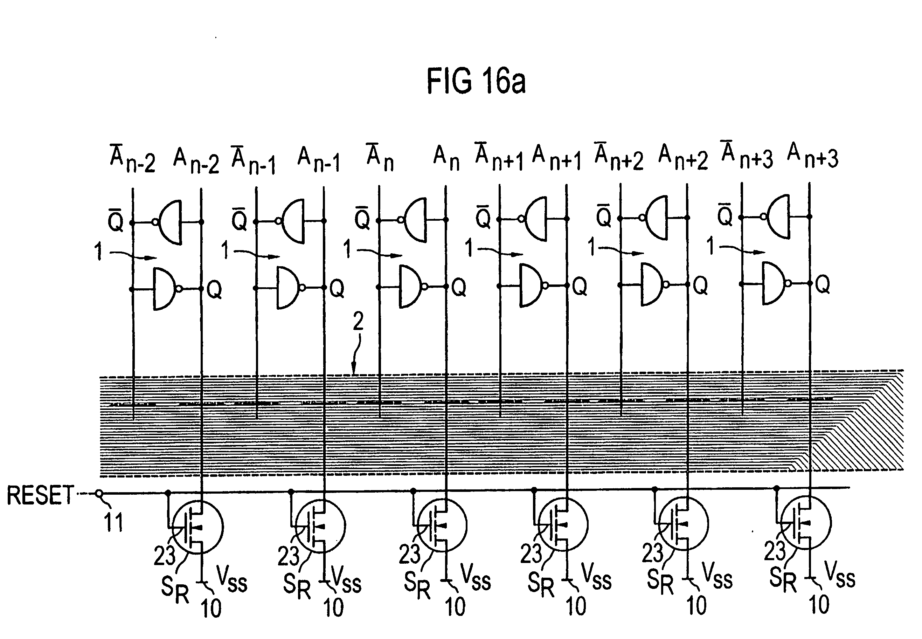

Die Figur 16a zeigt die schaltungstechnische Realisierung der Initialisierung nach Figur 14a in analoger Darstellung, wobei nur die Speicher 1 wie bei den Figuren 8 bis 14 dargestellt sind, die Schiebeschaltung 2 dagegen nur als Block dargestellt ist. Die Rücksetzvorrichtung ist dadurch realisiert, daß zwischen jeden Ausgang $A_j$, j = ... n-2, n-1, n, n+1, n+2, n+3, ... und das Potential $V_{SS}$ je ein n-MOS-Transistor als weiterer Schalter $S_R$ eingefügt ist Es genügt, diese Transistoren $S_R$ hinsichtlich ihrer Abmessungen minimal auszulegen. An die den Steueranschluß 23 der weiteren Schalter $S_R$ bildenen Gateanschlüsse dieser zusätzlichen Transistoren ist das H-aktiven Signal RESET angelegt.

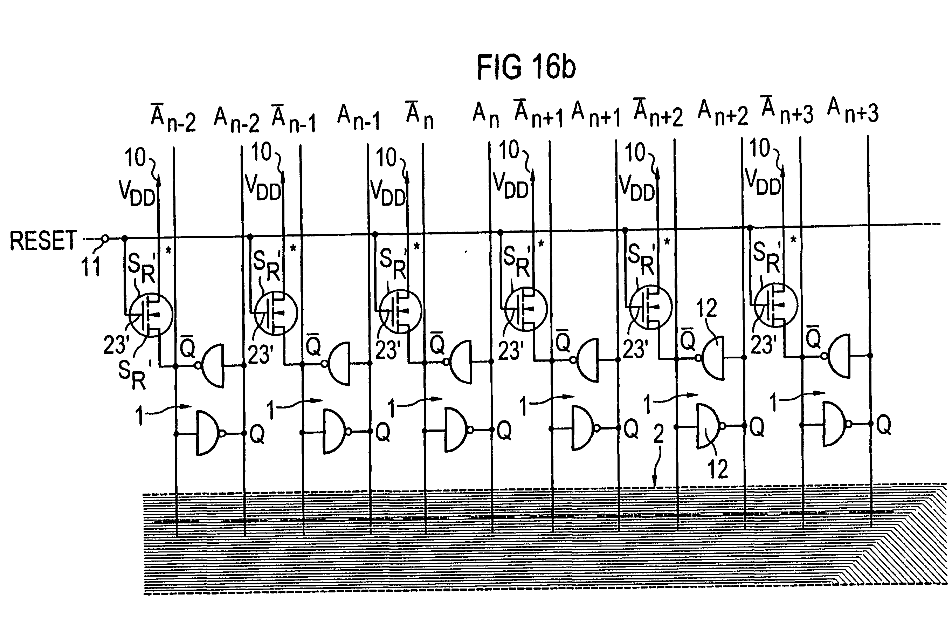

Die Figur 16b zeigt die schaltungstechnische Realisierung der Initialisierung nach Figur 14d in analoger Darstellung, wobei nur die Speicher 1 wie bei den Figuren 8 bis 14 dargestellt sind, die Schiebeschaltung 2 dagegen nur als Block dargestellt ist. Hier werden zwischen die Ausgänge $\bar{A}_j$ und ein Versorgungspotential $V_{DD}$ p-MOS-Transistoren $S_R'$ eingefügt, deren Gateanschlüsse 23' mit dem Anschluß 11 zum Anlegen des hier L-aktiven Signals RESET verbunden sind. Aus den schon bezüglich der Figur 11 beschriebenen Gründen können diese auch hier mit einem Sternchen (*) gekennzeichneten Transistoren jedoch nicht Minimalabmessungen haben. Eine geeignete Dimensionierung kann z.B. darin bestehen, ihnen die fünffache Weite eines Minimaltransistors zu geben.

Die Figur 18 zeigt beispielhaft die Auswahl genau einer Speicherzelle innerhalb einer Speichermatrix mit Hilfe eines Spalterpointers und eines Zeilenpointers, deren jeder mit einer erfindungsgemäßen Pointerschaltung realisiert sein kann.

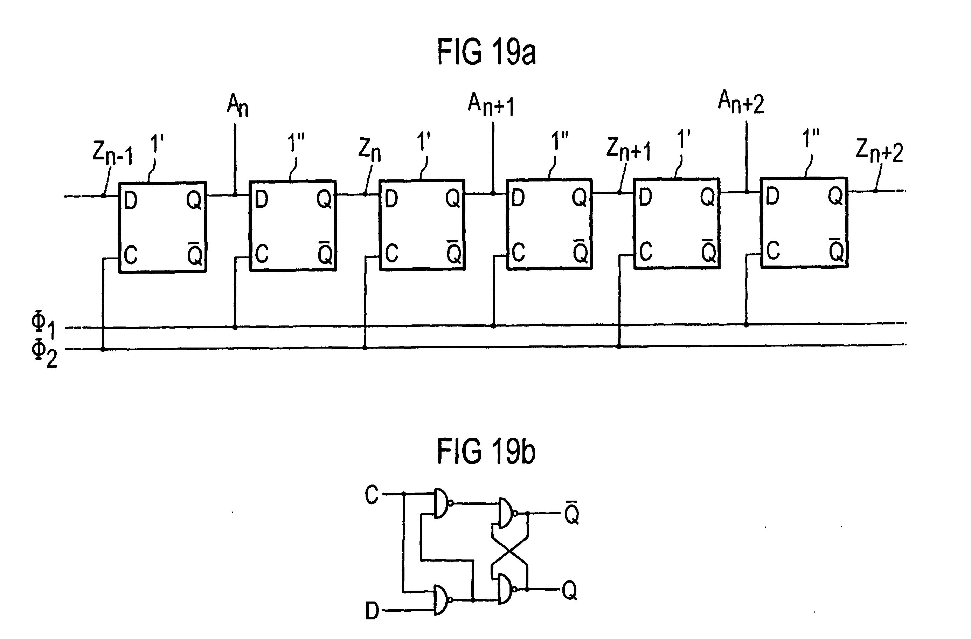

Die Figur 19 zeigt ein Beispiel einer Pointer-Schaltung in Form eines herkömmlichen Master-Slave-Schieberegisters aus D-Flipflops. An Ausgängen der Zwischenspeicher 1" liegen Signale ... $Z_n$, $Z_{n+1}$, $Z_{n+2}$, ... an. Die eigentlichen Ausgänge ... $A_n$, An+1, An+2 ... des Schieberegisters befinden sich jeweils an einem Ausgang Q eines Hauptspeichers 1'. Mit dem Taktsignsl $\Phi_1$ wird hier das Datum der Ausgänge ... $A_n$, $A_{n+1, n+2}$ ... der Hauptspeicher 1' in die Zwischenspeicher 1" übertragen, so daß dann $Z_n = A_{n+1}$, ... gilt. Nachdem die Eingänge der Zwischenspeicher 1" durch das Taktsignal $\Phi_1$ wieder verriegelt worden sind, können die Daten der Zwischenspeicher 1" durch Aktivierung der Eingänge C der Hauptspeicher 1' mit dem Taktsignal $\Phi_1$ wieder verriegelt worden sind, können die Daten der Eingänge C der Hauptspeicher 1' mit dem Taktsignal $\Phi_2$ in die folgende Haupt- und Zwischenspeicherstufe übernommen werden, so daß nun $A_n = Z_{n1}$, $A_{n+1} = Z_n$, $A_{n+2} = Z_{n+1}$, ... gilt.

Die Figur 19a zeigt ein Beispiel für den Aufbau eines D-Flipflops aus 4 NAND-Gattern (siehe [2]).

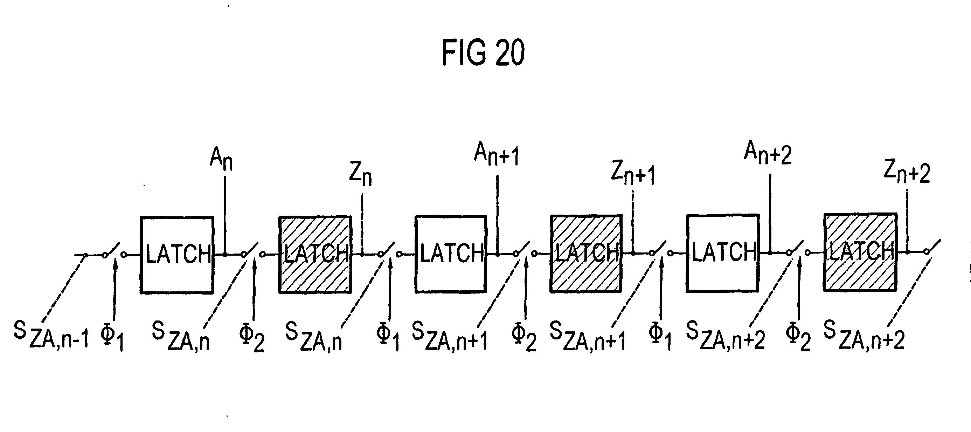

In der Figur 20 ist als weiteres Beispiel eine Pointer-Schaltung in Form eines anderen herkömmlichen Master-Slave-Schieberegisters dargestellt. An Ausgängen von Zwischenspeichern 1" liegen Signale $Z_n$ an. Die eigentlichen Ausgänge ... $A_n$, An+1, An+2 ... des Schieberegisters befinden sich jeweils an einem Ausgang Q eines Hauptspeichers 1'. Hierbei erfolgt der Datenübertrag der Ausgänge ... $A_n$, $A_{n+1}$, $A_{n+1}$, ... der Hauptspeicher 1' in die Zwischenspeicher 1" durch Schließen von Schaltern $S_{AZ,n}$, $S_{AZ,n+1}$, ..., der Übertrag aus den Zwischenspeichern 1" in die nachfolgende Haupt- und Zwischenspeicherstufe erfolgt durch Schließen der Schalter $S_{ZA,n}$, $S_{ZA,n+1}$ ...

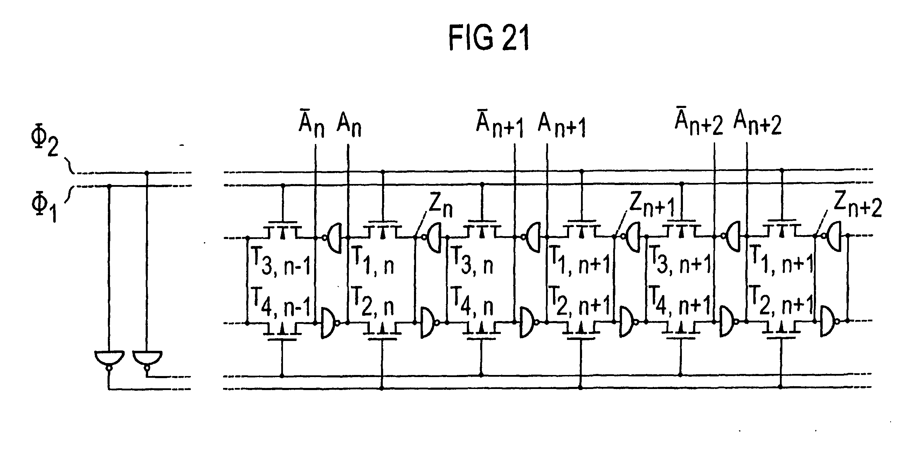

Die Figur 21 zeigt eine mögliche Realisierung der Pointer-Schaltung nach Figur 20 in CMOS-Technik (siehe [3]), wobei die Schalter $S_{AZ}$ aus Transfer-Gates $T_{1,n}$, $T_{2,n}$, $T_{3,n}$, $T_{4,n}$, $T_{1,n+1}$, $T_{2,n+1}$, $T_{3,n+1}$, $T_{4,n+1}$, ... bestehen, deren jedes durch einen n-und einen p-Kanal-Transistor gebildet ist. Die Speicher 1' und 1" sind aus jeweils zwei mitgekoppelten Invertern aufgebaut.

Bei der Schaltung nach Figur 21 erfolgt jeweils eine Invertierung des Signales nach jedem Speicher. Diese Inversion des Signales nach jeder Haupt- und Zwischenspeicherstufe wurde in die Figur 21 nicht mit aufgenommen, da sie für die prinzipielle Beschreibung dieser Schaltung nicht wesentlich ist.

Unabhängig von der verwendeten Technologie benötigen alle diese bisher bekannten Pointer-Schaltungen eine relativ hohe Anzahl an Bauelementen pro Pointer-Ausgang. Dieser relativ hohe Platzbedarf kann sich insbesondere in Anwendungen gemäß Figur 17 sehr nachteilig auswirken, da die Zeilen- und Spaltenanschlüsse bei bestimmten Technologien bzw. bei bestimmten Architekturvarianten des Zellenfeldes sehr geringe Abstände haben.

Anders als die herkömmlichen Pointerschaltungen nach den Figuren 19 bis 21 benötigt eine erfindungsgemäße Pointer-Schaltung keine Zwischenspeicher. Das bedeutet, daß bei einer derfindungsgemäßen Pointer-Schaltung pro Ausgang $A_j$, j = 1, 2, ...n-2, n-1, n, n+1, n+2, ... nur genau ein Speicher 1 benötigt wird. Dadurch wird der Aufwand an benötigten Bauelementen erheblich reduziert, was zu einem wesentlich geringeren Flächenbedarf gegenüber den herkömmlichen Pointerschaltungen führt. Dieses ist z.B. dann unumgänglich, wenn diese Schaltungen wie in Figur 17 skizziert zur Auswahl einer Speicherzelle innerhalb einer Speichermatrix genutzt werden und die Zeilen- bzw. Spaltenleitungen sehr geringe Abstände aufweisen (siehe [1]).

Im Gegensatz zu bislang bekannten Pointer-Schaltungen in Form von Schieberegistern kann eine erfindungsgemäße Pointerschaltung nicht beliebige Datenketten schieben. Vielmehr muß der logische Zustand am Ausgang $A_{j-1}$ und $A_{j+1}$ der Speicher 1, die dem Speicher 1 nächstbenachbart , dessen Ausgang $A_j$ den einen logischen Zustand aufweist, beispielsweise "1", immmer der andere logische Zustand, beispielsweise "0" sein. (Das bedeutet die Bedingung $A_j$ = "1" impliziert $A_{j-1}$ = $A_{j+1}$ = "0". Diese Bedingung ist jedoch für den Betrieb einer Schaltung als Pointer sowieso zwingend notwendig.

Literatur

[1] Paul-Werner von Basse, Michael Bollu, Roland Thewes, Doris Schmitt-Landsiedel GR 95 P 1289 (= EP-A 0 738 974)

[2] U. Tietze, Ch. Schenk, "Halbleiter-Schaltungstechnik", Springer Verlag, 9. Auflage, 1990

[3] N.H.E. Weste, K. Eshraghian, "Principles of CMOS VLSI Design", Addison-Wesley Publishing Company, 1993

[4] L. Risch, F. Hofmann, W. Rösner, W. Krautschneider, "Verfahren zur Herstellung einer Festwertspeicherzellenanordnung mit vertikalen MOS-Transistoren", GR 94 P 1778 DE (= amtl. Aktenzeichen P 44 37 581)

[5] W. Krautschneider, L. Risch, F. Hofmann, W. Rösner, "Festwertspeicherzellenanordnung und Verfahren zu deren Herstellung",

GR 94 P 1719 (= EP-A 0 784 866)

**Patentansprüche**

1. Pointer-Schaltung mit einer vorgegebenen Anzahl von Ausgängen ($A_j$, j = 1, 2, ... n-2, n-1, n, n+1, n+2, ...), denen jeweils ein komplementärer Ausgang ($\overline{A}_j$, j = 1, 2) zugeordnet ist, und zum Auswählen eines ersten Ausgangs ($A_n$) derart, dass der erste Ausgang als einziger auf einem ersten vorbestimmten ("1") von zwei logisch unterscheidbaren Zuständen ("1", "0") liegt, alle übrigen Ausgänge (...$A_{n-2}$, $A_{n-1}$, $A_{n+1}$, $A_{n+2}$...) dagegen auf einem zweiten logischen Zustand ("0") liegen und nicht ausgewählt sind, und zum Weiterschieben des ersten logischen Zustands ("1") von dem ersten Ausgang ($A_n$) zu einem zweiten, dem ersten Ausgang nächstbenachbarten Ausgang ($A_{n+1}$) durch Eingabe eines Taktsignals ($\Phi_1$, $\Phi_2$, $\Phi_3$, $\Phi_4$, $\Phi$), so dass nach diesem Weiterschieben der zweite Ausgang ($A_{n+1}$) auf dem ersten logischen Zustand ("1") liegt und ausgewählter Ausgang ist, während alle übrigen Ausgänge (... $A_{n-2}$, $A_{n-1}$, $A_n$, $A_{n+2}$ ...) einschließlich des ersten Ausgangs ($A_n$) auf dem zweiten logischen Zustand ("0") liegen und nicht ausgewählt sind, wobei

   - jedem Ausgang (... $A_{n-2}$, $A_{n-1}$, $A_n$, $A_{n+1}$, $A_{n+2}$ ...) individuell je genau ein statischer Speicher (1), der als einstufiges Latch ausgebildet ist, zugeordnet ist, so dass die Speicher in einer Reihe angeordnet sind und wobei jeder der Speicher einen ersten und einen zweiten zum ersten komplementären Speicheranschluss (Q, $\overline{Q}$)

aufweist, derart, dass sich die ersten und die zweiten Speicheranschlüsse (Q, $\overline{Q}$) stets auf zwei voneinander verschiedenen gespeicherten logischen Zuständen ("1", "0"; "0", "1") befinden, dass

- der erste Speicheranschluss (Q) jedes Speichers (1) mit dem diesem Speicher (1) zugeordneten Ausgang verbunden ist, und dass
- eine mit dem ersten Speicheranschluss (Q) jedes Speichers (1) verbundene Schiebeschaltung (2) zum Erzeugen des ersten logischen Zustandes ("1") an dem ersten Speicheranschluss (Q) eines ersten Speichers (1) und zum Weiterschieben des ersten logischen Zustands ("1") von dem ersten Speicheranschluss (Q) des ersten Speichers (1) zu dem ersten Speicheranschluss (Q) eines dem ersten Speicher (1) nächstbenachbarten zweiten Speichers (1) durch Eingabe wenigstens eines Taktsignals ($\Phi$) vorgesehen ist, die zugleich bewirkt, dass mit Ausnahme des nächst benachbarten zweiten Speichers (1), dessen erster Speicheranschluss (Q) auf dem ersten logischen Zustand ("1") liegt, die ersten Speicheranschlüsse (Q) aller übrigen Speicher (1) auf dem anderen logischen Zustand ("0") liegen, wobei die Schiebeschaltung (2) aufweist:
- pro Speicher (1) je einen diesem Speicher (1) individuell zugeordneten steuerbaren ersten Schalter (S), der zwischen den ersten Speicheranschluss (Q) dieses Speichers (1) und einem Anschluss (10) zum Anlegen eines Potentials ($V_{SS}$;) geschaltet ist und einen Steuereingang (20) zum Anlegen eines Schaltsignals zum wahlweisen Schließen und/oder Sperren des ersten Schalters (S) aufweist und
- pro Speicher (1) je einen diesem Speicher (1) individuell zugeordneten steuerbaren zweiten Schalter (S), der zwischen den zweiten Speicheranschluss ($\overline{Q}$) dieses Speichers (1) und einem Anschluss (10) zum Anlegen eines Potentials ($\Phi_1$, $\Phi_2$, $\Phi_3$, $\Phi_4$, $\Phi$) geschaltet ist und einen Steuereingang (20) zum Anlegen eines Schaltsignals zum wahlweisen Schließen und/oder Sperren des zweiten Schalters (S) aufweist.

2. Schaltung nach Anspruch 1, **dadurch gekennzeichnet, daß**

- jeder der zweiten Schalter (S) mit dem Anschluss (10) zum Anlegen des Potentials ($\Phi_1$, $\Phi_2$) so mit einem ersten oder einem zweiten Taktsignal ($\Phi_1$, $\Phi_2$) verbunden ist, dass die zweiten Schalter (S) der Reihe nach abwechselnd mit dem ersten Taktsignal ($\Phi_1$) und mit dem zweiten Taktsignal ($\Phi_2$) verbunden sind, und
- der erste Speicheranschluss (Q) des ersten Speichers (1) an den Steuereingang (20) des mit dem ersten Speicheranschluss (Q) des nächst benachbarten zweiten Speichers (1) verbundenen Schalter (S) und an den Steuereingang (20) eines dem ersten Speicher (1) nächstbenachbarten anderen dritten Speicher (1) zugeordneten und mit dem zweiten Speicheranschluss ($\overline{Q}$) des dritten Speichers (1) verbundenen zweiten Schalter (S) angeschlossen ist.

3. Schaltung nach Anspruch 2, **dadurch gekennzeichnet, dass** jeder der ersten Schalter (S) mit einem Anschluss (10) zum Anlegen eines Bezugspotentials ($V_{SS}$) verbunden ist.

4. Schaltung nach Anspruch 2, **dadurch gekennzeichnet, dass** jeder der ersten Schalter (S) mit einem Anschluss (10) zum Anlegen eines dritten oder eines vierten Taktsignals ($\Phi_3$, $\Phi_4$) derart verbunden ist, dass die ersten Schalter (S) der Reihe nach abwechselnd mit einem Anschluss (10) zum Anlegen des dritten Taktsignals ($\Phi_3$) und mit einem Anschluss (10) zum Anlegen des vierten Taktsignals ($\Phi_4$) verbunden sind.

5. Schaltung nach Anspruch 1, **dadurch gekennzeichnet, dass**

- jeder der ersten Schalter (S) mit einem Anschluss (10) zum Anlegen eines bestimmten Bezugspotentials ($V_{SS}$) verbunden ist,
- jeder der zweiten Schalter (S) mit einem Anschluss (10) zum Anlegen des ersten oder zweiten Taktsignals ($\Phi_1$, $\Phi_2$) derart verbunden ist, dass die zweiten Schalter (S) der Reihe nach abwechselnd mit dem ersten Taktsignal ($\Phi_1$) und mit dem zweiten Taktsignal ($\Phi_2$) verbunden sind,
- der erste Speicheranschluss (Q) eines der Speicher (1) an den Steuereingang (20) des zweiten Schalters des dem einen Speicher (1) nächstbenachbarten Speicher (1) angeschlossen ist, und
- der Steuereingang (20) jedes Schalters (S) mit einem Anschluss (10) zum Anlegen eines dritten oder vierten Taktsignals ($\Phi_3$, $\Phi_4$) derart verbunden ist, dass die Steuereingänge (20) dieser Schalter (S) der Reihe nach abwechselnd mit dem dritten Taktsignal ($\Phi_3$) und mit dem vierten Taktsignal ($\Phi_4$) verbunden sind.

6. Schaltung nach Anspruch 1, **dadurch gekennzeichnet, dass**

- jeder der ersten Schalter (S) mit einem Anschluss (10) zum Anlegen eines Taktsignals ($\Phi_1$, $\Phi_2$) derart verbunden ist, dass die ersten Schalter (S) der Reihe nach abwechselnd mit einem ersten Taktsignal ($\Phi_1$) und mit einem zweiten Taktsignal ($\Phi_2$) verbunden sind,

- jeder der zweiten Schalter (S) mit einem bestimmten Bezugspotential ($V_{SS}$) verbunden ist,
- ein Anschluss (10) zum Anlegen des ersten oder des zweiten Taktsignals ($\Phi_1$, $\Phi_2$) über einen steuerbaren Zwischenschalter (S1) mit dem Steueranschluss (20) des mit dem zweiten Speicheranschluss ($\overline{Q}$) eines dem ersten Speicher (1) nächstbenachbarten zweiten Speichers (1) zugeordneten zweiten Schalter verbunden ist, und
- der erste Speicheranschluss (Q) des ersten Speichers (1) mit dem Steueranschluss (21) des zwischen den Anschluss (10) zum Anlegen des ersten oder des zweiten Taktsignals ($\Phi_1$, $\Phi_2$) angeordeten ersten Schalters und den mit dem zweiten Speicheranschluss ($\overline{Q}$) des zweiten Speichers (1) geschalteten Zwischenschalter (S1, S1')und mit dem Steueranschluss (20) des mit dem ersten Speicheranschluss (Q) eines dem einen Speicher (1) nächstbenachbarten anderen dritten Speichers (1) verbundenen ersten Schalters (S) verbunden ist.

7. Schaltung nach Anspruch 6, **dadurch gekennzeichnet, daß** der Zwischenschalter (S1') eine zu einem der Schalter (S) komplementäre Steuercharakteristik aufweist.

8. Schaltung nach Anspruch 6 oder 7, **dadurch gekennzeichnet, dass** der zweite Speicheranschluss ($\overline{Q}$) des ersten Speichers (1) mit einem Steuereingang (22) eines weiteren Zwischenschalters (S2) verbunden ist, der zwischen den Steueranschluss (20) des mit dem zweiten Speicheranschluss ($\overline{Q}$) eines diesem Speicher (1) nächstbenachbarten Speichers (1) verbunden ist.

9. Schaltung nach Anspruch 1, **dadurch gekennzeichnet, dass**

- jeder einem Speicher (1) individuell zugeordnete steuerbare Schalter (S), der einerseits mit dem ersten Speicheranschluss (Q) dieses Speichers (1) verbunden ist, andererseits mit einem Anschluss (10) zum Anlegen eines bestimmten Bezugspotentials ($V_{SS}$) verbunden ist,
- jedem übernächsten Speicher (1) in der Reihe der Speicher (1) je ein steuerbarer Schalter (S) individuell zugeordnet ist, der einerseits mit dem zweiten Speicheranschluss ($\overline{Q}$) dieses übernächsten Speichers (1) verbunden ist, andererseits mit einem Anschluss (10) zum Anlegen eines Taktsignals ($\Phi$) verbunden ist,
- der erste Speicheranschluss (Q) jedes zwischen zwei benachbarten übernächsten Speichern (1) befindlichen Speichers (1) mit dem Steuereingang (20) des mit dem bestimmten Speicheranschluss (Q) eines benachbarten übernächsten Speichers (1) verbundenen Schalters (S) und dem Steuereingang (20) des mit dem zweiten Speicheranschluss ($\overline{Q}$) des anderen benachbarten übernächsten Speichers (1) verbundenen Schalters (S) verbunden ist, und
- zwischen den Steuereingang (20) des mit dem ersten Speicheranschluss (Q) jedes übernächsten Speichers (1) verbundenen Schalters (S) und einen Anschluss (10) zum Anlegen des Taktsignals ($\Phi$) je ein zusätzlicher Schalter (S') mit je einem Steuereingang (20') zum Anlegen eines Schaltimpulses zum wahlweisen Schließen und/oder Sperren des zusätzlichen Schalters (S') und einer zu einem Schalter (S) komplementären Steuercharakteristik geschaltet ist, wobei der zweite Speicheranschluss ($\overline{Q}$) dieses übernächsten Speichers (1) mit dem Steuereingang (20') dieses zusätzlichen Schalters (S') verbunden ist.

10. Schaltung nach Anspruch 1, **dadurch gekennzeichnet, dass**

- jeder der zweiten Schalter (S) mit einem Anschluss (10) zum Anlegen eines bestimmten Bezugspotentials ($V_{SS}$) verbunden ist,
- zwischen den Steuereingang (20) des mit dem zweiten Speicherausgang ($\overline{Q}$) jedes Speichers (1) verbundenen zweiten Schalters (S) und einen Anschluss (10) zum Anlegen des ersten oder zweiten Taktsignals ($\Phi_1$, $\Phi_2$) je ein diesem Speicher (1) zugeordneter zusätzlicher Schalter (S') mit je einem Steuereingang (20') zum Anlegen eines Schaltimpulses zum wahlweisen Schließen und/oder Sperren des zusätzlichen Schalters (S') und einer zu einem Schalter (S) komplementären Steuercharakteristik geschaltet ist, derart, dass diese zusätzlichen Schalter (S') der Reihe nach abwechselnd mit dem ersten Taktsignal ($\Phi_1$) und mit dem zweiten Taktsignal ($\Phi_2$) verbunden sind, und
- der Steuereingang (20') eines einem Speicher (1) zugeordneten zusätzlichen Schalters (S') mit dem zweiten Speicheranschluss (Q) eines diesem Speicher (1) nächstbenachbarten Speichers (1) verbunden ist.

## Claims

1. Pointer circuit having a predetermined number of outputs ($A_j$, j = 1, 2, ... n-2, n-1, n, n+1, n+2,...), which are assigned in each case a complementary output ($\overline{A}_j$, j = 1, 2), and for the selection of a first output ($A_n$) in such a way that the first output is the only output to be at a first predetermined state ("1") from two logically distinguishable states ("1", "0"), whereas all the remaining outputs (...$A_{n-2}$, $A_{n-1}$, $A_{n+1}$) are at a second logic state ("0") and are not selected, and for shifting onwards the first logic state ("1") from the first output ($A_n$) to a second output ($A_{n+1}$), which is closest adjacent to the first output, by the inputting of a clock signal ($\Phi_1$, $\Phi_2$, $\Phi_3$, $\Phi_4$, $\Phi$), so that, after this shifting onwards, the second output ($A_{n+1}$) is at the first logic state ("1") and is the selected output, while all the remaining outputs (...$A_{n-2}$, $A_{n-1}$, $A_n$, $A_{n+2}$...) including the first output ($A_n$) are at the second logic state ("0") and are not selected,

- each output (...$A_{n-2}$, $A_{n-1}$, $A_n$, $A_{n+1}$, $A_{n+2}$...) being individually assigned in each case precisely one static latch (1), designed as a single-stage latch, so that the latches are arranged in a series, and each of the latches having a first latch terminal (Q) and a second latch terminal ($\overline{Q}$) complementary to the first latch terminal, in such a way that the first and the second latch terminals (Q, $\overline{Q}$) are always at two mutually different stored logic states ("1", "0"; "0", "1"),
- the first latch terminal (Q) of each latch (1) being connected to the output assigned to this latch (1), and
- provision being made of a shift circuit (2) - connected to the first latch terminal (Q) of each latch (1) - for generating the first logic state ("1") at the first latch terminal (Q) of a first latch (1) and for shifting onwards the first logic state ("1") from the first latch terminal (Q) of the first latch (1) to the first latch terminal (Q) of a second latch (1), which is closest adjacent to the first latch (1), by the inputting of at least one clock signal ($\Phi$), which simultaneously has the effect that, with the exception of the closest adjacent second latch (1), the first latch terminal (Q) of which is at the first logic state ("1"), the first latch terminals (Q) of all the remaining latches (1) are at the other logic state ("0"), the shift circuit (2) having:
- per latch (1) in each case a controllable first switch (S) individually assigned to this latch (1), which switch is connected between the first latch terminal (Q) of this latch (1) and a terminal (10) for application of a potential ($V_{ss}$;) and has a control input (20) for application of a switching signal for optionally closing and/or inhibiting the first switch (S), and
- per latch (1) in each case a controllable second switch (S) individually assigned to this latch (1), which switch is connected between the second latch terminal ($\overline{Q}$) of this latch (1) and a terminal (10) for application of a potential ($\Phi_1$, $\Phi_2$, $\Phi_3$, $\Phi_4$, $\Phi$) and has a control input (20) for application of a switching signal for optionally closing and/or inhibiting the second switch (S).

2. Circuit according to Claim 1, **characterized in that**

- each of the second switches (S) is connected to the terminal (10) for application of the potential ($\Phi_1$, $\Phi_2$) with a first or a second clock signal ($\Phi_1$, $\Phi_2$) such that the second switches (S) are in turn alternately connected to the first clock signal ($\Phi_1$) and to the second clock signal ($\Phi_2$), and
- the first latch terminal (Q) of the first latch (1) is connected to the control input (20) of the switch (S) connected to the first latch terminal (Q) of the closest adjacent, second latch (1), and is connected to the control input (20) of a second switch (S), which is assigned to the other third latch (1) closest adjacent to the first latch (1) and is connected to the second latch terminal ($\overline{Q}$) of the third latch (1).

3. Circuit according to Claim 2, **characterized in that** each of the first switches (S) is connected to a terminal (10) for application of a reference potential ($V_{ss}$).

4. Circuit according to Claim 2, **characterized in that** each of the first switches (S) is connected to a terminal (10) for application of a third or a fourth clock signal ($\Phi_3$, $\Phi_4$) in such a way that the first switches (S) are in turn alternately connected to a terminal (10) for application of the third clock signal ($\Phi_3$) and to a terminal (10) for application of the fourth clock signal ($\Phi_4$).

5. Circuit according to Claim 1, **characterized in that**

- each of the first switches (S) is connected to a terminal (10) for application of a specific reference potential ($V_{ss}$),
- each of the second switches (S) is connected to a terminal (10) for application of the first or second clock signal ($\Phi_1$, $\Phi_2$) in such a way that the second switches (S) are in turn alternately connected to the first clock signal ($\Phi_1$) and to the second clock signal ($\Phi_2$),
- the first latch terminal (Q) of one of the latches (1) is connected to the control input (20) of the second switch of the latch (1) closest adjacent to the first latch (1), and
- the control input (20) of each switch (S) is connected to a terminal (10) for application of a third or fourth clock signal ($\Phi_3$, $\Phi_4$) in such a way that the control inputs (20) of these switches (S) are in turn alternately connected to the third clock signal ($\Phi_3$) and to the fourth clock signal ($\Phi_4$).

6. Circuit according to Claim 1, **characterized in that**

- each of the first switches (S) is connected to a terminal (10) for application of a clock signal ($\Phi_1$, $\Phi_2$) in such a way that the first switches (S) are in turn alternately connected to a first clock signal ($\Phi_1$) and to a second clock signal ($\Phi_2$),
- each of the second switches (S) is connected to a specific reference potential ($V_{ss}$),
- a terminal (10) for application of the first or of the second clock signal ($\Phi_1$, $\Phi_2$) is connected via a controllable intermediate switch (S1) to the control terminal (20) of the second switch assigned to the second latch terminal ($\overline{Q}$) of a second latch (1) closest adjacent to the first latch (1), and
- the first latch terminal (Q) of the first latch (1) is connected to the control terminal (21) of the first switch arranged between the terminal (10) for application of the first or of the second clock signal ($\Phi_1$, $\Phi_2$) and the intermediate switch (S1, S1') connected to the second latch terminal ($\overline{Q}$) of the second latch (1) and to the control terminal (20) of the first switch (S) connected to the first latch terminal (Q) of another, third latch (1) closest adjacent to the first latch (1).

7. Circuit according to Claim 6, **characterized in that** the intermediate switch (S1') has a complementary control characteristic with respect to one of the switches (S).

8. Circuit according to Claim 6 or 7, **characterized in that** the second latch terminal ($\overline{Q}$) of the first latch (1) is connected to a control input (22) of a further intermediate switch (S2), which is connected between the control terminal (20) of the to the second latch terminal ($\overline{Q}$) of a latch (1) closest adjacent to the said latch (1).

9. Circuit according to Claim 1, **characterized in that**

- each controllable switch (S) individually assigned to a latch (1), which switch on the one hand is connected to the first latch terminal (Q) of the said latch (1), on the other hand is connected to a terminal (10) for application of a specific reference potential ($V_{ss}$),
- each next but one latch (1) in the series of latches (1) is individually assigned a respective controllable switch (S) which on the one hand is connected to the second latch terminal ($\overline{Q}$) of the said next but one latch (1) and on the other hand is connected to a terminal (10) for application of a clock signal ($\Phi$),
- the first latch terminal (Q) of each latch (1) situated between two adjacent next but one latches (1) is connected to the control input (20) of the switch (S) connected to the specific latch terminal (Q) of one adjacent next but one latch (1) and the control input (20) of the switch (S) connected to the second latch terminal ($\overline{Q}$) of the other adjacent next but one latch (1), and
- between the control input (20) of the switch (S) connected to the first latch terminal (Q) of each next but one latch (1) and a terminal (10) for application of the clock signal ($\Phi$) there is connected a respective additional switch (S') with a respective control input (20') for application of a switching pulse for optionally closing and/or inhibiting the additional switch (S') and a complementary control characteristic with respect to a switch (S), the second latch terminal ($\overline{Q}$) of the said next but one latch (1) being connected to the control input (20') of the said additional switch (S').

10. Circuit according to Claim 1, **characterized in that**

- each of the second switches (S) is connected to a terminal (10) for application of a specific reference potential ($V_{ss}$),
- between the control input (20) of the second switch (S) connected to the second latch output ($\overline{Q}$) of each latch (1) and a terminal (10) for application of the first or second clock signal ($\Phi_1$, $\Phi_2$) there is connected a respective additional switch (S') - assigned to the said latch (1) - with a respective control input (20') for application of a switching pulse for optionally closing and/or inhibiting the additional switch (S') and a complementary control characteristic with respect to a switch (S), in such a way that these additional switches (S') are in turn alternately connected to the first clock signal ($\Phi_1$) and to the second clock signal ($\Phi_2$), and
- the control input (20') of an additional switch (S') assigned to a latch (1) is connected to the second latch terminal (Q) of a latch (1) closest adjacent to the said latch (1).

**Revendications**

1. Circuit de pointage avec un nombre prédéterminé de sorties ($A_j$, j = 1, 2, ... n-2, n-1, n, n+1, n+2, ...) à chacune desquelles est affectée une sortie complémentaire ($\bar{A}_j$, j = 1, 2) et, pour sélectionner une première sortie ($A_n$) de telle façon que la première sortie se trouve seule à un premier état prédéterminé (« 1 ») parmi deux états logiquement différentiables (« 1 », « 0 »), toutes les autres sorties (... $A_{n-2}$, $A_{n-1}$, $A_{n+1}$, $A_{n+2}$ ...) se trouvent au contraire à un deuxième état logique (« 0 ») et ne sont pas sélectionnées et, pour décaler le premier état logique (« 1 ») de la première sortie ($A_n$) à une deuxième sortie ($A_{n+1}$) immédiatement voisine de la première sortie en introduisant un signal d'horloge ($\Phi_1$, $\Phi_2$, $\Phi_3$, $\Phi_4$, $\Phi$) de façon que, après ce décalage, la deuxième sortie ($A_{n+1}$) se trouve au premier état logique (« 1 ») et est la sortie sélectionnée tandis que toutes les autres sorties (... $A_{n-2}$, $A_{n-1}$, $A_n$, $A_{n+2}$ ...), y compris la première sortie ($A_n$), se trouvent au deuxième état logique (« 0 ») et ne sont pas sélectionnées, où

- il est affecté individuellement à chaque sortie (... $A_{n-2}$, $A_{n-1}$, $A_n$, $A_{n+1}$, $A_{n+2}$ ...) exactement un registre statique (1) réalisé sous la forme d'une bascule monostable de sorte que les registres sont disposés en série et chacun des registres présente une première borne de registre et une deuxième borne de registre complémentaire de la première (Q, $\bar{Q}$) telles que les première et deuxième bornes de registre (Q, $\bar{Q}$) se trouvent toujours à deux états logiques mémorisés différents l'un de l'autre (« 1 », « 0 » ; « 0 », « 1 »), où
- la première borne de registre (Q) de chaque registre (1) est reliée à la sortie affectée à ce registre (1), et où
- il est prévu un circuit à décalage (2) relié à la première borne de registre (Q) de chaque registre (1) pour générer le premier état logique (« 1 ») sur la première borne de registre (Q) d'un premier registre (1) et pour décaler le premier état logique (« 1 ») de la première borne de registre (Q) du premier registre (1) à la première borne de registre (Q) d'un deuxième registre (1) immédiatement voisin du premier registre (1) en introduisant au moins un signal d'horloge ($\Phi$), lequel circuit assure en même temps que, à l'exception du deuxième registre immédiatement voisin (1) dont la première borne de registre (Q) se trouve au premier état logique (« 1 »), les premières bornes de registre (Q) de tous les autres registres (1) se trouvent à l'autre état logique (« 0 »), ledit circuit à décalage (2) présentant :

- pour chaque registre (1), un premier commutateur (S) commandable affecté individuellement à ce registre (1), qui est monté entre la première borne de registre (Q) de ce registre (1) et une borne (10) pour appliquer un potentiel ($V_{ss}$), et une entrée de commande (20) pour appliquer un signal de commutation pour fermer et/ ou verrouiller au choix le premier commutateur (S), et
- pour chaque registre (1), un deuxième commutateur commandable (S) affecté individuellement à ce registre (1), qui est monté entre la deuxième borne de registre ($\bar{Q}$) de ce registre (1) et une borne (10) pour appliquer un potentiel ($\Phi_1$, $\Phi_2$, $\Phi_3$, $\Phi_4$, $\Phi$), et une entrée de commande (20) pour appliquer un signal de commutation pour fermer et/ou verrouiller au choix le deuxième commutateur (S).

2. Circuit selon la revendication 1, **caractérisé en ce que**

- chacun des deuxièmes commutateurs (S) est relié à la borne (10) pour appliquer le potentiel ($\Phi_1$, $\Phi_2$) de telle façon que, avec un premier ou un deuxième signal d'horloge ($\Phi_1$, $\Phi_2$), les deuxièmes commutateurs (S) sont reliés séquentiellement et alternativement au premier signal d'horloge ($\Phi_1$) et au deuxième signal d'horloge ($\Phi_2$), et
- la première borne de registre (Q) du premier registre (1) est connectée à l'entrée de commande (20) du commutateur (S) relié à la première borne de registre (Q) du deuxième registre (1) immédiatement voisin et à l'entrée de commande (20) d'un deuxième commutateur (S) affecté au troisième autre registre (1) immédiatement voisin du premier registre (1) et relié à la deuxième borne de registre ($\bar{Q}$) du troisième registre (1).

3. Circuit selon la revendication 2, **caractérisé en ce que** chacun des premiers commutateurs (S) est relié à une borne (10) pour appliquer un potentiel de référence ($V_{ss}$).

4. Circuit selon la revendication 2, **caractérisé en ce que** chacun des premiers commutateurs (S) est relié à une borne (10) pour appliquer un troisième ou un quatrième signal d'horloge ($\Phi_3$, $\Phi_4$) de telle façon que les premiers commutateurs (S) sont reliés séquentiellement et alternativement à une borne (10) pour appliquer le troisième signal d'horloge ($\Phi_3$) et à une borne (10) pour appliquer le quatrième signal d'horloge ($\Phi_4$).

5. Circuit selon la revendication 1, **caractérisé en ce que**

- chacun des premiers commutateurs (S) est relié à une borne (10) pour appliquer un potentiel de référence donné ($V_{ss}$),
- chacun des deuxièmes commutateurs (S) est relié à une borne (10) pour appliquer le premier ou deuxième

signal d'horloge ($\Phi_1$, $\Phi_2$) de telle façon que les deuxièmes commutateurs (S) sont reliés séquentiellement et alternativement au premier signal d'horloge ($\Phi_1$) et au deuxième signal d'horloge ($\Phi_2$),

- la première borne de registre (Q) de l'un des registres (1) est connectée à l'entrée de commande (20) du deuxième commutateur du registre (1) immédiatement voisin dudit registre (1), et
- l'entrée de commande (20) de chaque commutateur (S) est reliée à une borne (10) pour appliquer un troisième ou un quatrième signal d'horloge ($\Phi_3$, $\Phi_4$) de telle façon que les entrées de commande (20) de ces commutateurs (S) sont reliées séquentiellement et alternativement au troisième signal d'horloge ($\Phi_3$) et au quatrième signal d'horloge ($\Phi_4$).

6. Circuit selon la revendication 1, **caractérisé en ce que**

- chacun des premiers commutateurs (S) est relié à une borne (10) pour appliquer un signal d'horloge ($\Phi_1$, $\Phi_2$) de telle façon que les premiers commutateurs (S) sont reliés séquentiellement et alternativement à un premier signal d'horloge ($\Phi_1$) et à un deuxième signal d'horloge ($\Phi_2$),
- chacun des deuxièmes commutateurs (S) est relié à un potentiel de référence donné ($V_{ss}$),
- une borne (10) pour appliquer le premier ou le deuxième signal d'horloge ($\Phi_1$, $\Phi_2$) est reliée par le biais d'un commutateur intermédiaire commandable (S1) à la borne de commande (20) du deuxième commutateur relié à la deuxième borne de registre ($\bar{Q}$) d'un deuxième registre (1) affecté au premier registre (1) immédiatement voisin, et
- la première borne de registre (Q) du premier registre (1) est reliée à la borne de commande (21) du premier commutateur disposé entre la borne (10) du premier commutateur pour appliquer le premier ou le deuxième signal d'horloge ($\Phi_1$, $\Phi_2$) et le commutateur intermédiaire (S1, S1') connecté à la deuxième borne de registre ($\bar{Q}$) du deuxième registre (1) et à la borne de commande (20) du premier commutateur (S) relié à la première borne de registre (Q) d'un autre troisième registre (1) immédiatement voisin dudit registre (1).

7. Circuit selon la revendication 6, **caractérisé en ce que** le commutateur intermédiaire (S1') présente une caractéristique de commande complémentaire de l'un des commutateurs (S).

8. Circuit selon la revendication 6 ou la revendication 7, **caractérisé en ce que** la deuxième borne de registre ($\bar{Q}$) du premier registre (1) est reliée à une entrée de commande (22) d'un autre commutateur intermédiaire (S2) qui est monté entre la borne de commande (20) de la deuxième borne de registre ($\bar{Q}$) d'un registre (1) immédiatement voisin dudit registre (1).

9. Circuit selon la revendication 1, **caractérisé en ce que**

- chaque commutateur commandable (S) individuellement affecté à un registre (1), qui est relié d'une part à la première borne de registre (Q) de ce registre (1), est relié d'autre part à une borne (10) pour appliquer un potentiel de référence donné ($V_{ss}$),
- un commutateur commandable (S) est individuellement affecté à chaque registre (1) au-delà du suivant dans la série des registres (1), lequel est relié d'une part à la deuxième borne de registre ($\bar{Q}$) de ce registre (1) au-delà du suivant et d'autre part à une borne (10) pour appliquer un signal d'horloge ($\Phi$),
- la première borne de registre (Q) de chaque registre (1) se trouvant entre deux registres (1) voisins, l'un au-delà du suivant, est reliée à l'entrée de commande (20) du commutateur (S) relié à la borne de registre (Q) déterminée d'un registre (1) voisin au-delà du suivant et à l'entrée de commande (20) du commutateur (S) relié à la deuxième borne de registre ($\bar{Q}$) de l'autre registre (1) voisin au-delà du suivant, et
- un commutateur supplémentaire (S') ayant respectivement une entrée de commande (20') pour appliquer une impulsion de commutation pour fermer et/ou verrouiller au choix le commutateur supplémentaire (S') et une caractéristique de commande complémentaire d'un commutateur (S) est monté entre l'entrée de commande (20) du commutateur (S) relié à la première borne de registre (Q) de chaque registre (1) au-delà du suivant et une borne (10) pour appliquer le signal d'horloge ($\Phi$), la deuxième borne de registre ($\bar{Q}$) de ce registre (1) au-delà du suivant étant reliée à l'entrée de commande (20') de ce commutateur supplémentaire (S').

10. Circuit selon la revendication 1, **caractérisé en ce que**

- chacun des deuxièmes commutateurs (S) est relié à une borne (10) pour appliquer un potentiel de référence donné ($V_{ss}$),
- un commutateur supplémentaire (S') affecté à ce registre (1), ayant respectivement une entrée de commande (20') pour appliquer une impulsion de commande pour fermer et/ou verrouiller au choix le commutateur supplémentaire (S') et une caractéristique de commande complémentaire d'un commutateur (S), est monté entre l'entrée de commande (20) du deuxième commutateur (S) relié à la deuxième sortie de registre ($\overline{Q}$) de chaque registre (1) et une borne (10) pour appliquer le premier ou le deuxième signal d'horloge ($\Phi_1$, $\Phi_2$) de telle façon que ce commutateur supplémentaire (S') est relié séquentiellement et alternativement au premier signal d'horloge ($\Phi_1$) et au deuxième signal d'horloge ($\Phi_2$), et

- l'entrée de commande (20') d'un commutateur supplémentaire (S') affecté à un registre (1) est reliée à la deuxième borne de registre (Q) d'un registre (1) immédiatement voisin dudit registre (1).

FIG 1

FIG 1a

EP 0 905 706 B1

FIG 2

FIG 2a

EP 0 905 706 B1

FIG 3

FIG 3a

EP 0 905 706 B1

FIG 4

FIG 4a

EP 0 905 706 B1

FIG 5

EP 0 905 706 B1

FIG 5a

FIG 6

FIG 6a

$\Phi_1$

$\Phi_2$

$\longrightarrow t$

FIG 7

FIG 7a

FIG 8

# FIG 9

EP 0 905 706 B1

FIG 10

FIG 11

# FIG 12

EP 0 905 706 B1

# FIG 13

EP 0 905 706 B1

# FIG 14a

EP 0 905 706 B1

# FIG 14b

## FIG 14c

EP 0 905 706 B1

# FIG 14d

EP 0 905 706 B1

# FIG 15a

# FIG 15b

EP 0 905 706 B1

# FIG 16a

EP 0 905 706 B1

# FIG 16b

EP 0 905 706 B1

# FIG 17

# FIG 18

## FIG 19a

## FIG 19b

EP 0 905 706 B1

**FIG 20**

# FIG 21

EP 0 905 706 B1